# EUROPEAN PATENT APPLICATION

(11) **EP 4 468 846 A1**
(43) Date of publication of application: **27.11.2024**
(21) Application number: 24176863.9
(22) Date of filing: 20.05.2024
(51) Int. Cl.: H10K 59/131

(54) **DISPLAY DEVICE**

(30) Priority: 22.05.2023 KR 20230065421
(71) Applicant: Samsung Display Co., Ltd., Yongin-si, Gyeonggi-do 17113 (KR)
(72) Inventor: SHIN, Dong Hee, Yongin-si 17113 (KR); SON, Sun Kwun, Yongin-si 17113 (KR)
(74) Representative: Walaski, Jan Filip

(57) **Abstract**

A display device includes a first gate line and first and second auxiliary gate lines protruding from the first gate line and first and second pixels each comprising a first transistor and a second transistor, wherein the second transistor of each of the first and second pixels comprises an active region, a drain electrode on one side of the active region, a source electrode on the other side of the active region and a gate electrode overlapping with the active region, and wherein the gate electrodes of the first and second pixels are respectively connected to the first and second auxiliary gate lines.

## Description

### CROSS-REFERENCE TO RELATED APPLICATION

The present application claims priority to Korean Patent Application No. 10-2023-0065421, filed on May 22, 2023, in the Korean Intellectual Property Office.

### BACKGROUND

### 1. Field

The disclosure relates to a display device.

### 2. Description of Related Art

The importance of display devices has steadily increased with the development of multimedia technology. Accordingly, various kinds of display devices have been developed, such as a liquid crystal display (LCD) device, an organic light emitting diode (OLED) display device, and the like.

From among the display devices, a self-light emitting display device includes a self-light emitting element, such as an organic light emitting element. The self-light emitting element may include two opposite electrodes, and a light emitting layer interposed between the two opposite electrodes. In the case of the organic light emitting element used as the self-light emitting element, the electrons and holes from the two electrodes are recombined in the light emitting layer to produce excitons, which transition from an excited state to a ground state, for emitting light.

The self-light emitting display device is attracting attention as a next-generation display device, because it is able to meet high display quality requirements such as wide viewing angles, high brightness and contrast, and quick response speeds, as well as having low power consumption, and being lightweight and thin due to not having a necessity for a power source, such as a backlight unit.

The above information disclosed in this Background section is for enhancement of understanding of the background of the present disclosure, and therefore, it may contain information that does not constitute prior art.

### SUMMARY

One or more embodiments of the present disclosure are directed to a display device including a node connected to a pixel electrode of one pixel that overlaps with a node connected to a gate electrode of another pixel, and in which a coupling phenomenon in which a voltage is applied to the pixel electrode of the one pixel by a voltage applied to the pixel electrode of the other pixel is minimized or reduced.

One or more embodiments of the present disclosure are directed to a display device having an increased opening ratio by minimizing or reducing a color difference that may be caused by coupling between the pixel electrode of the one pixel and a transistor of the other pixel.

One or more embodiments of the present disclosure are directed to a display device in which a color cast phenomenon in which a color other than white or black is displayed at a boundary between white and black is minimized or reduced.

However, the aspects and features of the present disclosure are not restricted to those set forth herein. The above and other aspects and features of the present disclosure will become more apparent to those having ordinary skill in the art by referencing the detailed description of the present disclosure below and the drawings.

According to one or more embodiments of the present disclosure, a display device includes: a first gate line including: a main line; and first and second auxiliary lines protruding from the main line; and first and second pixels, each including a first transistor. The first transistor of each of the first and second pixels includes: a first active region; a first drain electrode on one side of the first active region; a first source electrode on another side of the first active region; and a first gate electrode overlapping with the first active region. The first gate electrodes of the first and second pixels are respectively connected to the first and second auxiliary lines.

In an embodiment, the first auxiliary line may be located on one side of the first pixel; and the second auxiliary line may be located on another side of the first pixel.

In an embodiment, the display device may further include first and second data lines. The first drain electrodes of the first and second pixels may be respectively connected to the first and second data lines, the first data line may be located on one side of the first pixel, and the second data line may be located on another side of the first pixel.

In an embodiment, the first and second data lines may be configured to apply first and second data signals, respectively, to the first transistors of the first and second pixels; and a direction in which the first data signal is applied may be opposite to a direction in which the second data signal is applied.

In an embodiment, the first transistor of the first pixel may be located on one side of the first pixel, and the first transistor of the second pixel may be located on another side of the second pixel.

In an embodiment, the display device may further include a first voltage line on one side of the first auxiliary line. The first pixel may further include a second transistor, and the second transistor of the first pixel may include: a second active region; a second drain electrode on one side of the second active region; a second source electrode on another side of the second active region; and a second gate electrode overlapping with the second active region. The second drain electrode of the first pixel may be connected to the first voltage line.

In an embodiment, the first data line may be located on one side of the first voltage line.

In an embodiment, the first data line may be located between the first voltage line and the first auxiliary line.

In an embodiment, the first pixel may further include a third transistor; the third transistor of the first pixel may include: a third active region; a third drain electrode on one side of the third active region; a third source electrode on another side of the third active region; and a third gate electrode overlapping with the third active region; and the first to third transistors of the first pixel may be located on one side of the first pixel.

In an embodiment, the first pixel may further include a first pixel electrode connected to the second source electrode of the first pixel; the first data line and the first drain electrode of the first pixel may be connected to each other through a first connection electrode; and the first connection electrode may not overlap with the first pixel electrode.

In an embodiment, the display device may further include at least one voltage line between the first auxiliary line and the first data line, and the first connection electrode may overlap with at least one of the at least one voltage line.

In an embodiment, the second pixel may further include a second transistor and a second pixel electrode; the second transistor of the second pixel may include: a second active region; a second drain electrode on one side of the second active region; a second source electrode on another side of the second active region; and a second gate electrode overlapping with the second active region; the second pixel electrode may be connected to the second source electrode of the second pixel; and the second pixel electrode may not overlap with the first transistor of the first pixel.

According to one or more embodiments of the present disclosure, a display device includes: first and second data lines; a first gate line including a main line, and an auxiliary line protruding from the main line; and first and second pixels, each including a first transistor. The first transistor of each of the first and second pixels includes: a first active region; a first drain electrode on one side of the first active region; a first source electrode on another side of the first active region; and a first gate electrode overlapping with the first active region. The first drain electrodes of the first and second pixels are respectively connected to the first and second data lines, the first gate electrode of each of the first and second pixels is connected to the auxiliary line, and a branch point of the auxiliary line is located between the first and second data lines.

In an embodiment, the first and second data lines may be located on one side of the first pixel.

In an embodiment, the display device may further include: a third data line; and a third pixel including the first transistor. The first drain electrode of the third pixel may be connected to the third data line, the first gate electrode of the third pixel may be connected to the auxiliary line, and the third data line may be located on an opposite side of the auxiliary line with the first data line interposed therebetween in a plan view.

In an embodiment, the first to third data lines and the auxiliary line may be adjacent to each other.

In an embodiment, the auxiliary line may overlap with at least one of the first or second data lines.

In an embodiment, the first pixel may further include a second transistor and a first pixel electrode; the second transistor of the first pixel may include: a second active region; a second drain electrode on one side of the second active region; a second source electrode on another side of the second active region; and a second gate electrode overlapping with the second active region; the first pixel electrode may be connected to the second source electrode of the first pixel; the first source electrode of the first pixel and the second gate electrode of the first pixel may be electrically connected to each other through a first connection electrode; and the first pixel electrode may overlap with the first connection electrode.

In an embodiment, the second pixel may further include a second transistor and a second pixel electrode; the second transistor of the second pixel may include: a second active region; a second drain electrode on one side of the second active region; a second source electrode on another side of the second active region; and a second gate electrode overlapping with the second active region. The second pixel electrode may be connected to the second source electrode of the second pixel; and the second pixel electrode may not overlap with the first transistor of the first pixel.

In an embodiment, the auxiliary line may not overlap with the second pixel electrode.

In an embodiment, the auxiliary line may include a straight portion, and at least one bent portion connected to the straight portion; and the bent portion may be spaced from the second pixel electrode in a plan view.

In an embodiment, an extension direction of the bent portion may be parallel to an extension direction of an end of the second pixel electrode adjacent to the bent portion.

According to one or more embodiments of the present disclosure, a display device includes: first and second unit pixels adjacent to each other, each of the first and second unit pixels including: first and second data lines; a first gate line including a main line, and first and second auxiliary lines protruding from the main line; and first and second pixels, each including a first transistor. The first transistor of each of the first and second pixels of the second unit pixel includes: a first active region; a first drain electrode on one side of the first active region; a first source electrode on another side of the first active region; and a first gate electrode overlapping with the first active region. The first drain electrode of the first pixel of the second unit pixel is connected to the first data line of the first unit pixel, and the first drain electrode of the second pixel of the second unit pixel is connected to the second data line of the second unit pixel.

In an embodiment, the first gate electrodes of the first and second pixels of the second unit pixel may be respectively connected to the first and second auxiliary lines of the second unit pixel; the first auxiliary line of the second unit pixel may be located on one side of the first pixel of the second unit pixel; and the second auxiliary line of the second unit pixel may be located on another side of the first pixel of the second unit pixel.

According to one or more embodiments of the present disclosure, in a display device, when a node connected to a pixel electrode of one pixel overlaps with a node connected to a gate electrode of another pixel, a coupling phenomenon in which a voltage is applied to the pixel electrode of the one pixel by a voltage applied to the pixel electrode of the other pixel may be minimized or reduced.

According to one or more embodiments of the present disclosure, in a display device, an opening ratio may be increased by minimizing or reducing a color difference that may be caused by coupling between the pixel electrode of the one pixel and a transistor of the other pixel.

According to one or more embodiments of the present disclosure, in a display device, a color cast phenomenon in which a color other than white or black is displayed at a boundary between white and black may be minimized or reduced.

However, the aspects and features of the present disclosure are not limited to those above, and various other aspects and features may be incorporated herein.

### BRIEF DESCRIPTION OF THE DRAWINGS

The above and other aspects and features of the present disclosure will be more clearly understood from the following detailed description of the illustrative, non-limiting embodiments with reference to the accompanying drawings, in which:
FIG. 1 is a plan view illustrating a display device according to an embodiment;
FIG. 2 is a diagram illustrating pixels and lines of the display device of Figure 1;
FIG. 3 is a circuit diagram of a first pixel of the display device;
FIG. 4 is a circuit diagram illustrating second and third pixels of the display device;
FIG. 5 is a plan view illustrating a thin film transistor layer, a pixel electrode, and a pixel defining layer of the display device;
FIG. 6 is a cross-sectional view taken along the line I-I' of FIG. 5;
FIG. 7 is a cross-sectional view taken along the line II-II' of FIG. 5;
FIG. 8 is a cross-sectional view taken along the lines III-III' and IV-IV' of FIG. 5;
FIG. 9 is an enlarged view of the area A of FIG. 5;
FIG. 10 is an enlarged view of the area B of FIG. 5;
FIG. 11 is a diagram illustrating pixels and lines of a display device according to another implementation;
FIG. 12 is a diagram illustrating pixels and lines of a display device according to another implementation;
FIG. 13 is a plan view illustrating a thin film transistor layer, a pixel electrode, and a pixel defining layer of a display device;
FIG. 14 is an enlarged view of the area C of FIG. 13;
FIG. 15 is a diagram illustrating pixels and lines of a display device according to another implementation;
FIG. 16 is a circuit diagram showing a pixel of a display device;
FIG. 17 is a plan view illustrating a thin film transistor layer, a pixel electrode, and a pixel defining layer of a display device;
FIG. 18 is an enlarged view of the area D of FIG. 17;
FIG. 19 is a cross-sectional view taken along the line V-V' of FIG. 18;
FIG. 20 is a cross-sectional view taken along the line VI-VI' of FIG. 18;
FIG. 21 is a diagram illustrating pixels and lines of a display device according to another implementation;
FIG. 22 is a plan view illustrating a thin film transistor layer, a pixel electrode, and a pixel defining layer of a display device;
FIG. 23 is an enlarged view of the area E of FIG. 22; and
FIG. 24 is a diagram illustrating pixels and lines of a display device according to another implementation.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

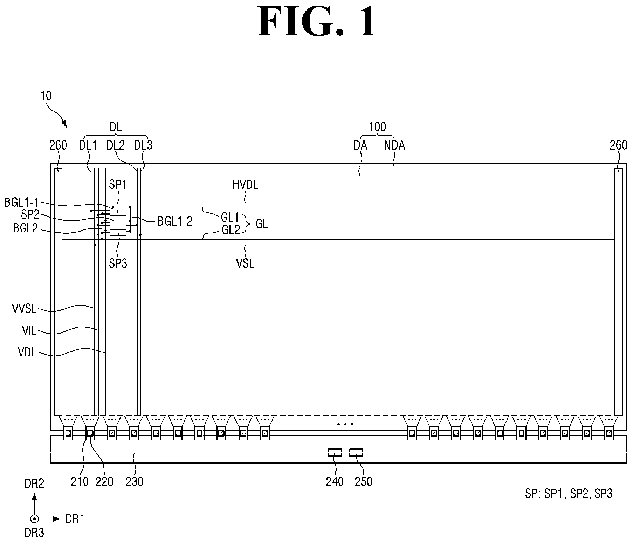

FIG. 1 is a plan view illustrating a display device.

Referring to FIG. 1, a display device 10 is a device for displaying a moving or still image, and may be used as a display screen of various suitable products, such as a television, a laptop computer, a monitor, a billboard, and an Internet of Things (IoT) device, as well as for various suitable portable electronic devices, such as a mobile phone, a smartphone, a tablet personal computer (PC), a smart watch, a watch phone, a mobile communication terminal, an electronic notebook, an eBook reader, a portable multimedia player (PMP), a navigation device, and an ultra-mobile PC (UMPC).

The display device 10 may include a display panel 100, a flexible film 210, a display driver 220, a circuit board 230, a timing controller 240, a power supply unit (e.g., a power supply or power supply device) 250, and a gate driver 260.

The display panel 100 may have a rectangular shape in a plan view. For example, in a plan view, the display panel 100 may have a rectangular shape having a long side extending in the first direction DR1 and a short side extending in the second direction DR2. A corner where the long side extending in the first direction DR1 and the short side extending in the second direction DR2 meet each other may be right-angled, or may be rounded with a suitable curvature (e.g., a predetermined curvature). The planar shape of the display panel 100 is not limited to the rectangular shape, and may be formed in another suitable polygonal shape, a circular shape or an elliptical shape. For example, the display panel 100 may be formed to be flat or substantially flat, but the present disclosure is not limited thereto. In another example, the display panel 100 may be bent with a suitable curvature (e.g., a predetermined curvature).

In the illustrated figures, the first direction DR1 and the second direction DR2 cross each other. For example, the first direction DR1 and the second direction DR2 may be orthogonal or substantially orthogonal to each other. In addition, the third direction DR3 crosses the first direction DR1 and the second direction DR2, and these directions may be, for example, perpendicular or substantially perpendicular directions that are orthogonal or substantially orthogonal to each other. In the present specification, each of the directions indicated by the arrows of the first to third directions DR1, DR2, and DR3 may be referred to as one side (e.g., in the corresponding direction), and an opposite direction thereto may be referred to as another side or the other side.

The display panel 100 may include a display area DA and a non-display area NDA.

The display area DA, which is an area for displaying an image, may be defined as the central area of the display panel 100. The display area DA may include a pixel SP, a gate line GL, a data line DL, an initialization voltage line VIL, a first voltage line VDL, a horizontal voltage line HVDL, a vertical voltage line VVSL, and a second voltage line VSL.

The pixel SP may be formed in each pixel area at crossings (e.g., intersections) of the data lines DL and the gate lines GL. The pixel SP may include first to third pixels SP1, SP2, and SP3. Each of the first to third pixels SP1, SP2, and SP3 may be connected to a corresponding gate line GL and a corresponding data line DL. Each of the first to third pixels SP1, SP2, and SP3 may be defined as a minimum unit area that outputs light.

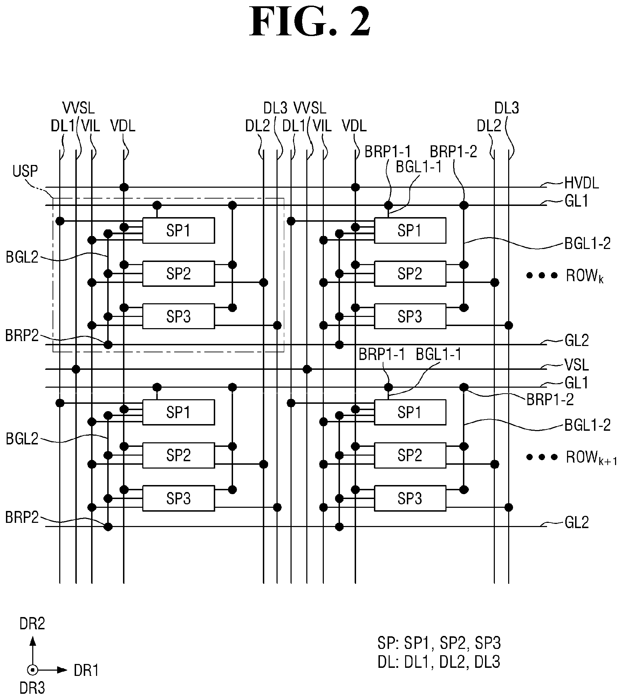

An area including first and second gate lines GL1 and GL2, the data line DL, the first voltage line VDL, the initialization voltage line VIL, the vertical voltage line VVSL, and the first to third pixels SP1, SP2, and SP3 may be defined as a single unit pixel USP (e.g., see FIG. 2) for displaying a desired color. The unit pixel USP may realize one color by combining the light emitted from the first to third pixels SP1, SP2, and SP3.

Each of the first to third pixels SP1, SP2, and SP3 may include an organic light emitting diode (OLED) having an organic light emitting layer, a quantum dot light emitting diode (LED) including a quantum dot light emitting layer, a micro LED, or an inorganic LED having an inorganic semiconductor.

The first pixel SP1 may emit light of a first color, such as red light. The second pixel SP2 may emit light of a second color, such as green light. The third pixel SP3 may emit light of a third color, such as blue light. Pixel circuits of the first pixel SP1, the second pixel SP2, and the third pixel SP3 may be sequentially arranged along the opposite direction of the second direction DR2, but the arrangement direction of the pixel circuits is not limited thereto.

The gate line GL may include the first gate line GL1 and the second gate line GL2.

A plurality of the first gate lines GL1 may extend in the first direction DR1, and may be spaced apart from each other along the second direction DR2. The first gate line GL1 may receive a first gate signal from the gate driver 260, and may supply the first gate signal to a first auxiliary gate line BGL1-1 and a second auxiliary gate line BGL1-2 extending in the direction opposite to the second direction DR2. The first auxiliary gate line BGL1-1 may extend from the first gate line GL1 to supply the first gate signal to the first pixel SP1. The second auxiliary gate line BGL1-2 may extend from the first gate line GL1 to supply the first gate signal to the second and third pixels SP2 and SP3.

A plurality of the second gate lines GL2 may extend in the first direction DR1, and may be spaced apart from each other along the second direction DR2. The second gate line GL2 may receive a second gate signal from the gate driver 260, and may supply the second gate signal to a third auxiliary gate line BGL2 extending in the second direction DR2. The third auxiliary gate line BGL2 may extend from the second gate line GL2 to supply the second gate signal to the first to third pixels SP1, SP2, and SP3.

A plurality of the data lines DL may extend in the second direction DR2, and may be spaced apart from each other along the first direction DR1. The data line DL may include first to third data lines DL1, DL2, and DL3. Each of the first to third data lines DL1, DL2, and DL3 may supply a data voltage to a corresponding pixel from among the first to third pixels SP1, SP2, and SP3. The first data line DL1 may be disposed on the left side of the vertical voltage line VVSL. The second and third data lines DL2 and DL3 may be disposed on the right side of the second auxiliary gate line BGL1-2.

A plurality of the initialization voltage lines VIL may extend in the second direction DR2, and may be spaced apart from each other along the first direction DR1. The initialization voltage line VIL may supply an initialization voltage received from the display driver 220 to the pixel circuit of each of the first to third pixels SP1, SP2, and SP3. The initialization voltage line VIL may receive a sensing signal from the pixel circuit of each of the first to third pixels SP1, SP2, and SP3 to supply the sensing signal the display driver 220.

A plurality of the first voltage lines VDL may extend in the second direction DR2, and may be spaced apart from each other along the first direction DR1. The first voltage line VDL may supply a driving voltage or a high potential voltage received from the power supply unit 250 to the first to third pixels SP1, SP2, and SP3.

A plurality of the horizontal voltage lines HVDL may extend in the first direction DR1, and may be spaced apart from each other along the second direction DR2. The horizontal voltage line HVDL may be connected to the first voltage line VDL. The horizontal voltage line HVDL may receive a driving voltage or a high potential voltage from the first voltage line VDL.

A plurality of the vertical voltage lines VVSL may extend in the second direction DR2, and may be spaced apart from each other along the first direction DR1. The vertical voltage line VVSL may be connected to the second voltage line VSL. The vertical voltage line VVSL may supply a low potential voltage received from the power supply unit 250 to the second voltage line VSL.

A plurality of the second voltage lines VSL may extend in the first direction DR1, and may be spaced apart from each other along the second direction DR2. The second voltage line VSL may supply the low potential voltage to the first to third pixels SP1, SP2, and SP3.

The connection relationships between the pixel SP, the gate line GL, the data line DL, the initialization voltage line VIL, the first voltage line VDL, and the second voltage line VSL may be variously modified in design according to the number and arrangement of the pixels SP.

The non-display area NDA may be defined as a remaining area of the display panel 100 except for the display area DA. For example, the non-display area NDA may include fan-out lines connecting the data line DL, the initialization voltage line VIL, the first voltage line VDL, and the vertical voltage line VVSL to the display driver 220, the gate driver 260, and a pad portion connected to the flexible film 210.

The flexible film 210 may be connected to the pad portion disposed below the non-display area NDA. Input terminals provided on one side of the flexible film 210 may be attached to the circuit board 230 by a film attaching process, and output terminals provided at another side of the flexible film 210 may be attached to the pad portion by the film attaching process. For example, the flexible film 210 may be bent like a tape carrier package or a chip on film. The flexible film 210 may be bent toward a lower portion (e.g., a rear or bottom surface) of the display panel 100 to reduce the bezel area of the display device 10.

The display driver 220 may be mounted on the flexible film 210. For example, the display driver 220 may be implemented as an integrated circuit (IC). The display driver 220 may receive digital video data and a data control signal from the timing controller 240, and according to the data control signal, may convert the digital video data to an analog data voltage, and may supply the analog data voltage to the data lines DL through the fan-out lines.

The circuit board 230 may support the timing controller 240 and the power supply unit 250, and may supply signals and power to the display driver 220. For example, the circuit board 230 may supply a signal supplied from the timing controller 240 and a power voltage supplied from the power supply unit 250 to the flexible film 210 and the display driver 220 to display an image on each pixel. As such, a signal line and a power line may be provided on the circuit board 230.

The timing controller 240 may be mounted on the circuit board 230, and receives image data and a timing synchronization signal supplied from the display driving system or a graphic device through a user connector provided on the circuit board 230. The timing controller 240 may generate the digital video data by arranging the image data according to (e.g., to fit) the pixel arrangement structure based on the timing synchronization signal, and may supply the generated digital video data to the display driver 220. The timing controller 240 may generate the data control signal and the gate control signal based on the timing synchronization signal. The timing controller 240 may control the data voltage supply timing of the display driver 220 based on the data control signal, and may control the gate signal supply timing of the gate driver 260 based on the gate control signal.

The power supply unit 250 may be disposed on the circuit board 230 to supply a power voltage to the flexible film 210 and the display driver 220. For example, the power supply unit 250 may generate and supply a driving voltage or a high potential voltage to the first voltage line VDL, may generate and supply a low potential voltage to the vertical voltage line VVSL, and may generate and supply an initialization voltage to the initialization voltage line VIL.

The gate driver 260 may be disposed on the left and right sides of the non-display area NDA. The gate driver 260 may generate the gate signal based on the gate control signal supplied from the timing controller 240. The gate control signal may include a start signal, a clock signal, and a power voltage, but the present disclosure is not limited thereto. The gate driver 260 may supply the gate signal to the gate line GL according to a suitable order (e.g., a set or predetermined order).

FIG. 2 is a diagram illustrating pixels and lines of a display device.

Referring to FIGS. 1 and 2, the pixels SP may include the first to third pixels SP1, SP2, and SP3. The pixel circuits of the first pixel SP1, the second pixel SP2, and the third pixel SP3 may be arranged along the opposite direction of the second direction DR2, but the arrangement direction of the pixel circuits is not limited thereto.

Each of the first to third pixels SP1, SP2, and SP3 may be connected to the first voltage line VDL, the initialization voltage line VIL, the gate line GL, and the data line DL.

The first voltage line VDL may extend in the second direction DR2. The first voltage line VDL may be disposed on the left side of the pixel circuits of the first to third pixels SP1, SP2, and SP3. The first voltage line VDL may supply a driving voltage or a high potential voltage to a transistor of each of the first to third pixels SP1, SP2, and SP3.

The horizontal voltage line HVDL may extend in the first direction DR1. The horizontal voltage line HVDL may be disposed above the first gate line GL1 disposed in a k^{th} row ROWₖ (k being a positive integer). The horizontal voltage line HVDL may be connected to the first voltage line VDL. The horizontal voltage line HVDL may receive a driving voltage or a high potential voltage from the first voltage line VDL.

The initialization voltage line VIL may extend in the second direction DR2. The initialization voltage line VIL may be disposed on the left side of the third auxiliary gate line BGL2. The initialization voltage line VIL may be disposed between the vertical voltage line VVSL and the third auxiliary gate line BGL2. The initialization voltage line VIL may supply an initialization voltage to the pixel circuit of each of the first to third pixels SP1, SP2, and SP3. The initialization voltage line VIL may receive a sensing signal from the pixel circuit of each of the first to third pixels SP1, SP2, and SP3 to supply the sensing signal the display driver 220.

The vertical voltage line VVSL may extend in the second direction DR2. The vertical voltage line VVSL may be disposed on the left side of the initialization voltage line VIL. The vertical voltage line VVSL may be connected between the power supply unit 250 and the second voltage line VSL. The vertical voltage line VVSL may supply the low potential voltage supplied from the power supply unit 250 to the second voltage line VSL.

The second voltage line VSL may extend in the first direction DR1. The second voltage line VSL may be disposed above the first gate line GL1 disposed in a (k+1)^{th} row ROWₖ₊₁ The second voltage line VSL may supply the low potential voltage received from the vertical voltage line VVSL to a light emitting element layer of the first to third pixels SP1, SP2, and SP3.

The first gate line GL1 may extend in the first direction DR1. The first gate line GL1 may be disposed above the pixel circuit of the first pixel SP1. The first auxiliary gate line BGL1-1 and the second auxiliary gate line BGL1-2 protrude (extend) from the first gate line GL1 in the direction opposite to the second direction DR2. The first gate line GL1 may supply the first gate signal received from the gate driver 260 to the first auxiliary gate line BGL1-1 and the second auxiliary gate line BGL1-2.

The first auxiliary gate line BGL1-1 may be branched from the first gate line GL1 at a first branch point BRP1-1, and extend in the direction opposite to the second direction DR2. The first auxiliary gate line BGL1-1 may be disposed above the first pixel SP1. The first auxiliary gate line BGL1-1 may supply the first gate signal received from the first gate line GL1 to the pixel circuit of the first pixel SP1.

The second auxiliary gate line BGL1-2 may be branched from the first gate line GL1 at a second branch point BRP1-2, and extend in the direction opposite to the second direction DR2. The second auxiliary gate line BGL1-2 may be disposed on the right side of the pixel circuits of the first to third pixels SP1, SP2, and SP3. The second auxiliary gate line BGL1-2 may supply the first gate signal received from the first gate line GL1 to the pixel circuits of the second and third pixels SP2 and SP3.

The second gate line GL2 may extend in the first direction DR1. The second gate line GL2 may be disposed below the pixel circuit of the third pixel SP3. The the third auxiliary gate line BGL2 protrudes from the second gate line GL2 in the second direction DR2. The second gate line GL2 may supply the second gate signal received from the gate driver 260 to the third auxiliary gate line BGL2.

The third auxiliary gate line BGL2 may be branched from the second gate line GL2 at a third branch point BRP2, and extend in the second direction DR2. The third auxiliary gate line BGL2 may be disposed on the left side of the first voltage line VDL. The third auxiliary gate line BGL2 may supply the second gate signal received from the second gate line GL2 to the pixel circuits of the first to third pixels SP1, SP2, and SP3.

The data lines DL may extend in the second direction DR2. The data lines DL may supply a data voltage to the pixels SP. The data lines DL may include the first to third data lines DL1, DL2, and DL3.

The first data line DL1 may extend in the second direction DR2. The first data line DL1 may be disposed on the left side of the vertical voltage line VVSL. The first data line DL1 may supply the data voltage received from the display driver 220 to the pixel circuit of the first pixel SP1.

The second data line DL2 may extend in the second direction DR2. The second data line DL2 may be disposed on the right side of the first auxiliary gate line BGL1-1. The second data line DL2 may supply the data voltage received from the display driver 220 to the pixel circuit of the second pixel SP2.

The third data line DL3 may extend in the second direction DR2. The third data line DL3 may be disposed on the right side of the second data line DL2. The third data line DL3 may supply the data voltage received from the display driver 220 to the pixel circuit of the third pixel SP3.

An area including the first and second gate lines GL1 and GL2, the data line DL, the first voltage line VDL, the initialization voltage line VIL, the vertical voltage line VVSL, and the first to third pixels SP1, SP2, and SP3 may be defined as the single unit pixel USP for displaying a desired color. The unit pixel USP may realize one color by combining the light emitted from the first to third pixels SP1, SP2, and SP3.

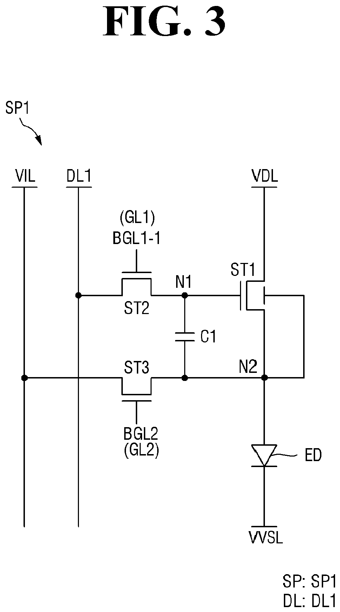

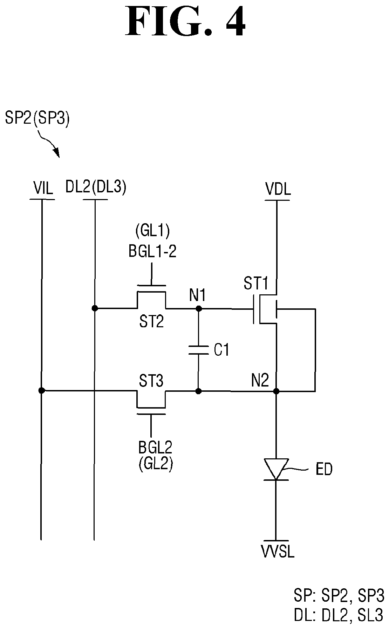

FIG. 3 is a circuit diagram of a first pixel of a display device. FIG. 4 is a circuit diagram illustrating second and third pixels of a display device.

Referring to FIGS. 3 and 4, each pixel SP may be connected to the first voltage line VDL (e.g., a corresponding first voltage line VDL), the data line DL (e.g., a corresponding data line DL), the initialization voltage line VIL (e.g., a corresponding initialization voltage line VIL), the first gate line GL1 (e.g., a corresponding first gate line GL1), the second gate line GL2 (e.g., a corresponding second gate line GL2), and the vertical voltage line VVSL (e.g., a corresponding vertical voltage line VVSL).

Each of the first to third pixels SP1, SP2, and SP3 may include a pixel circuit and a light emitting element ED. The pixel circuit of each of the first to third pixels SP1, SP2, and SP3 may include first to third transistors ST1, ST2, and ST3 and a first capacitor C1.

The first transistor ST1 may include an upper gate electrode, a lower gate electrode, a drain electrode, and a source electrode. The upper gate electrode of the first transistor ST1 may be connected to a first node N1. The lower gate electrode of the first transistor ST1 may be connected to a second node N2. The drain electrode of the first transistor ST1 may be connected to the first voltage line VDL. The source electrode of the first transistor ST1 may be connected to the second node N2. The first transistor ST1 may control a drain-source current thereof (e.g., a driving current) based on the data voltage applied to the upper gate electrode and the lower gate electrode. The first transistor ST1 may be a driving transistor for driving the light emitting element ED.

The light emitting element ED may emit light by receiving the driving current. The light emission amount or the luminance of the light emitting element ED may be proportional to the magnitude of the driving current. The light emitting element ED may be an organic light emitting diode (OLED) having an organic light emitting layer, a quantum dot light emitting diode (LED) including a quantum dot light emitting layer, a micro LED, or an inorganic LED having an inorganic semiconductor.

The first electrode of the light emitting element ED may be connected to the second node N2, and the second electrode of the light emitting element ED may be connected to the vertical voltage line VVSL. The first electrode of the light emitting element ED may be connected to the source electrode of the first transistor ST1, the drain electrode of the third transistor ST3, and the second capacitor electrode of the first capacitor C1, through the second node N2.

The second transistor ST2 may be turned on by the first gate signal of the first gate line GL1 to electrically connect the data line DL to the first node N1, which is the upper gate electrode of the first transistor ST1. The second transistor ST2 may be turned on according to the first gate signal to supply the data voltage to the first node N1. The gate electrode of the second transistor ST2 may be connected to the first gate line GL1, the drain electrode thereof may be connected to the data line DL, and the source electrode thereof may be connected to the first node N1. The source electrode of the second transistor ST2 may be connected to the upper gate electrode of the first transistor ST1 and a first capacitor electrode of the first capacitor C1 through the first node N1. The second transistor ST2 may be a switching transistor for controlling the current flowing through the first transistor ST1 and the light emitting element ED.

In more detail, in the first pixel SP1, the second transistor ST2 may be turned on by the first gate signal provided from the first auxiliary gate line BGL1-1 of the first gate line GL1 to electrically connect the first data line DL1 to the first node N1, which is the upper gate electrode of the first transistor ST1. The gate electrode of the second transistor ST2 of the first pixel SP1 may be connected to the first auxiliary gate line BGL1-1 of the first gate line GL1, and the drain electrode thereof may be connected to the first data line DL1.

The second transistors ST2 of the second and third pixels SP2 and SP3 may be turned on by the first gate signal provided from the second auxiliary gate line BGL1-2 of the first gate line GL1 to electrically connect the data lines DL2 and DL3 to the first nodes N1, respectively, which are the upper gate electrodes of the first transistors ST1 thereof. The gate electrodes of the second transistors ST2 of the second and third pixels SP2 and SP3 may be connected to the second auxiliary gate line BGL1-2 of the first gate line GL1, and the drain electrodes thereof may be connected to the second and third data lines DL2 and DL3, respectively.

The third transistor ST3 may be turned on by the second gate signal of the second gate line GL2 to electrically connect the initialization voltage line VIL to the second node N2, which is the source electrode of the first transistor ST1. The third transistor ST3 may be turned on according to the second gate signal to supply the initialization voltage to the second node N2. The third transistor ST3 may be turned on according to the second gate signal to supply the sensing signal to the initialization voltage line VIL. The gate electrode of the third transistor ST3 may be connected to the second gate line GL2, the drain electrode thereof may be connected to the second node N2, and the source electrode thereof may be connected to the initialization voltage line VIL. The drain electrode of the third transistor ST3 may be connected to the source electrode of the first transistor ST1, the second capacitor electrode of the first capacitor C1, and the first electrode of the light emitting element ED, through the second node N2. The third transistor ST3 may be a switching transistor for controlling the current flowing through the first transistor ST1 and the light emitting element ED.

In more detail, the third transistor ST3 may be turned on by the second gate signal provided from the third auxiliary gate line BGL2 of the second gate line GL2 to supply the initialization voltage to the second node N2 and/or the sensing signal to the initialization voltage line VIL. The gate electrode of the third transistor ST3 may be connected to the third auxiliary gate line BGL2 of the second gate line GL2.

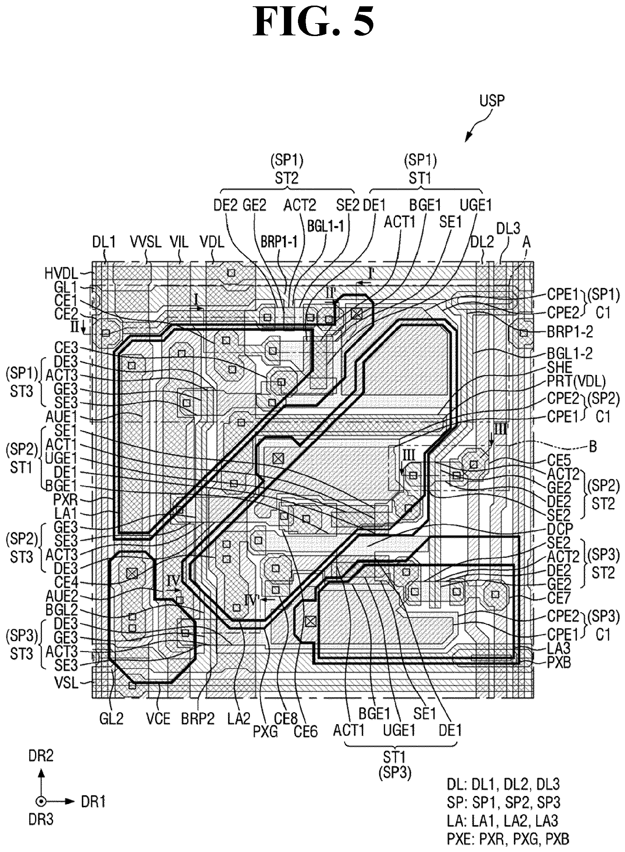

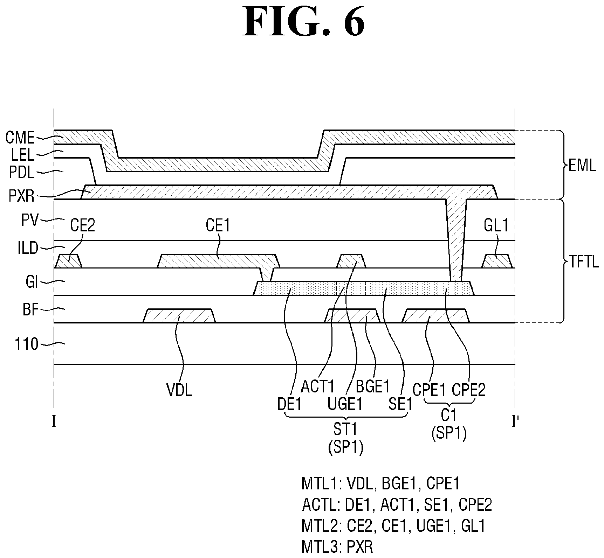

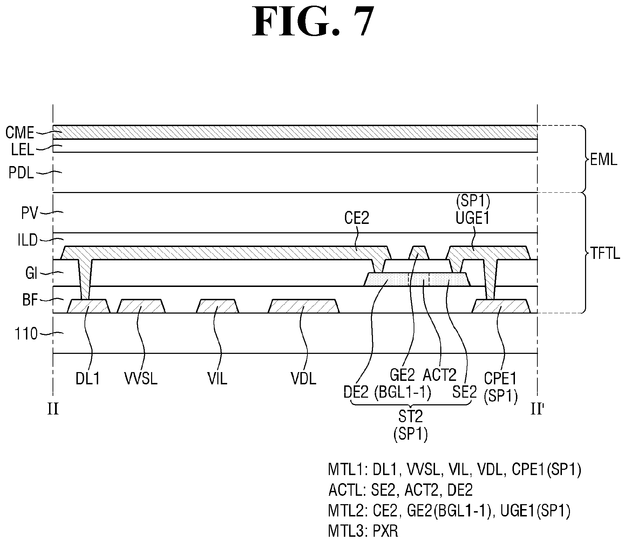

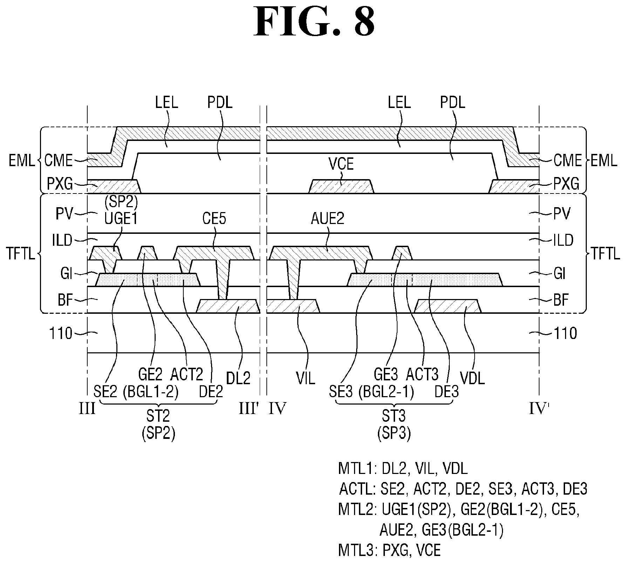

FIG. 5 is a plan view illustrating a thin film transistor layer, a pixel electrode, and a pixel defining layer of a display device. FIG. 6 is a cross-sectional view taken along the line I-I' of FIG. 5. FIG. 7 is a cross-sectional view taken along the line II-II' of FIG. 5. FIG. 8 is a cross-sectional view taken along the lines III-III' and IV-IV' of FIG. 5.

In FIG. 6, because the cross sections of the first transistors ST1 of the first to third pixels SP1, SP2, and SP3 are the same or substantially the same as (or similar to) each other, the cross section of the first transistor ST1 of the first pixel SP1 is illustrated as a representative example. In addition, in FIG. 8, because the cross sections of the second transistors ST2 of the second and third pixels SP2 and SP3 are the same or substantially the same as (or similar to) each other, the cross section of the second transistor ST2 of the second pixel SP2 is illustrated as a representative example. In addition, in FIG. 8, because the cross sections of the third transistors ST3 of the first to third pixels SP1, SP2, and SP3 are the same or substantially the same as (or similar to) each other, the cross section of the third transistor ST3 of the third pixel SP3 is illustrated as a representative example.

Referring to FIGS. 4 and 5 to 8, the display panel 100 may include a substrate 110, a thin film transistor layer TFTL, and a light emitting element layer EML.

The substrate 110 may include a transparent material. For example, the substrate 110 may include a transparent insulating material, such as glass, quartz, or the like. The substrate 110 may be a rigid substrate. However, the present disclosure is not limited thereto, and the substrate 110 may include a plastic such as polyimide, or may have flexible properties so it can be bent, folded, or rolled.

The thin film transistor layer TFTL may be disposed on the substrate 110. The thin film transistor layer TFTL may include a first metal layer MTL1 disposed on the substrate 110, a buffer layer BF covering the first metal layer MTL1, an active layer ACTL disposed on the buffer layer BF, a gate insulating layer GI covering the active layer ACTL, a second metal layer MTL2 disposed on the gate insulating layer GI, an interlayer insulating layer ILD covering the second metal layer MTL2, and a passivation layer PV covering the interlayer insulating layer ILD.

The first metal layer MTL1 may include the vertical voltage line VVSL, the initialization voltage line VIL, the first voltage line VDL, the data line DL, a first lower gate electrode BGE1, and a first capacitor electrode CPE1.

The active layer ACTL may include first to third drain electrodes DE1, DE2, and DE3, first to third source electrodes SE1, SE2, and SE3, first to third active regions ACT1, ACT2, and ACT3, a second capacitor electrode CPE2, and a drain connection portion DCP.

The second metal layer MTL2 may include the horizontal voltage line HVDL, the first gate line GL1, the second gate line GL2, the second voltage line VSL, a first upper gate electrode UGE1, second and third gate electrodes GE2 and GE3, first to eighth connection electrodes CE1, CE2, CE3, CE4, CE5, CE6, CE7, and CE8, first and second auxiliary electrodes AUE1 and AUE2, and a shielding electrode SHE.

The buffer layer BF may be disposed on the first metal layer MTL1. The buffer layer BF may be formed of multiple layers in which one or more inorganic layers from among a silicon nitride layer, a silicon oxynitride layer, a silicon oxide layer, a titanium oxide layer, and/or an aluminum oxide layer are alternately stacked.

The gate insulating layer GI may be disposed on the active layer ACTL. The gate insulating layer GI may include at least one of silicon oxide (SiOx), silicon nitride (SiNx), or silicon oxynitride (SiOxNy).

The interlayer insulating layer ILD may be disposed on the second metal layer MTL2. The interlayer insulating layer ILD may be formed of an inorganic layer, for example, such as a silicon nitride layer, a silicon oxynitride layer, a silicon oxide layer, a titanium oxide layer, or an aluminum oxide layer.

The passivation layer PV may be disposed on the interlayer insulating layer ILD. The passivation layer PV may be formed of an inorganic layer, for example, such as a silicon nitride layer, a silicon oxynitride layer, a silicon oxide layer, a titanium oxide layer, or an aluminum oxide layer.

The pixels SP may include the first to third pixels SP1, SP2, and SP3. The pixel circuits of the first pixel SP1, the second pixel SP2, and the third pixel SP3 may be arranged along the opposite direction of the second direction DR2, but the arrangement direction of the pixel circuits is not limited thereto.

The first voltage line VDL may extend in the second direction DR2. The first voltage line VDL may be disposed on the left side of the pixel circuits of the first to third pixels SP1, SP2, and SP3 in a plan view. The first voltage line VDL may be disposed in the first metal layer MTL1 on the substrate 110. The first voltage line VDL may overlap with the first connection electrode CE1, the fourth connection electrode CE4, and the shielding electrode SHE of the second metal layer MTL2.

The first connection electrode CE1 and the fourth connection electrode CE4 may extend in the first direction DR1 and the second direction DR2. The first connection electrode CE1 and the fourth connection electrode CE4 may be disposed at (e.g., in or on) the second metal layer MTL2. The first connection electrode CE1 and the fourth connection electrode CE4 may be connected to the first voltage line VDL. The first voltage line VDL may reduce a line resistance by being connected to the first connection electrode CE1 and the fourth connection electrode CE4.

The first connection electrode CE1 may be connected to the first drain electrode DE1 of the first transistor ST1 of the first pixel SP1. Accordingly, the first voltage line VDL may supply a driving voltage to the first pixel SP1 through the first connection electrode CE1.

The fourth connection electrode CE4 may be connected to the first drain electrode DE1 of the first transistor ST1 of each of the second pixel SP2 and the third pixel SP3. Accordingly, the first voltage line VDL may supply a driving voltage to the second pixel SP2 and the third pixel SP3 through the fourth connection electrode CE4.

The first voltage line VDL may further include a protrusion portion PRT. For example, the first voltage line VDL may include a main portion extending in the second direction DR2, and the protrusion portion PRT protruding from the main portion in the first direction DR1.

The protrusion portion PRT may be disposed between the first pixel SP1 and the second pixel SP2. For example, the protrusion portion PRT may be disposed between the first capacitor electrode CPE1 of the first pixel SP1 and the first capacitor electrode CPE1 of the second pixel SP2. The protrusion portion PRT may be spaced apart from each of the first capacitor electrode CPE1 of the first pixel SP1 and the first capacitor electrode CPE1 of the second pixel SP2 in the second direction DR2 by a suitable distance (e.g., a predetermined distance).

The protrusion portion PRT may receive a voltage having a potential different from that of the first capacitor electrode CPE1 of the first pixel SP1 and the first capacitor electrode CPE1 of the second pixel SP2. Accordingly, a coupling phenomenon may be minimized or reduced by blocking a voltage variation between the first capacitor electrode CPE1 of the first pixel SP1 and the first capacitor electrode CPE1 of the second pixel SP2.

The first voltage line VDL may be connected to the horizontal voltage line HVDL to supply a driving voltage.

The horizontal voltage line HVDL may extend in the first direction DR1. The horizontal voltage line HVDL may be disposed on the upper side of the first gate line GL1 in a plan view. The horizontal voltage line HVDL may be disposed in the second metal layer MTL2. The horizontal voltage line HVDL may be connected to the first voltage line VDL to receive the driving voltage.

The initialization voltage line VIL may extend in the second direction DR2. The initialization voltage line VIL may be disposed on the left side of the first voltage line VDL in a plan view. The initialization voltage line VIL may be disposed in the first metal layer MTL1. The initialization voltage line VIL may overlap with a second auxiliary electrode AUE2 of the second metal layer MTL2, and may be connected to the second auxiliary electrode AUE2. The initialization voltage line VIL may reduce a line resistance by being connected to the second auxiliary electrode AUE2.

The second auxiliary electrode AUE2 may extend in the second direction DR2. The second auxiliary electrode AUE2 may be disposed at (e.g., in or on) the second metal layer MTL2. The second auxiliary electrode AUE2 may be connected to the third source electrode SE3 of the third transistor ST3 of each of the first to third pixels SP1, SP2, and SP3. Accordingly, the initialization voltage line VIL may supply an initialization voltage to the third transistor ST3 of each of the first to third pixels SP1, SP2, and SP3 through the second auxiliary electrode AUE2, and may receive a sensing signal from the third transistor ST3.

The vertical voltage line VVSL may extend in the second direction DR2. The vertical voltage line VVSL may be disposed on the left side of the initialization voltage line VIL in a plan view. The vertical voltage line VVSL may be disposed in the first metal layer MTL1. The vertical voltage line VVSL may overlap with the first auxiliary electrode AUE1 of the second metal layer MTL2.

The first auxiliary electrode AUE1 may extend in the second direction DR2. The first auxiliary electrode AUE1 may be disposed at (e.g., in or on) the second metal layer MTL2. The first auxiliary electrode AUE1 may be connected to the vertical voltage line VVSL. The vertical voltage line VVSL may reduce a line resistance by being connected to the first auxiliary electrode AUE1.

The first auxiliary electrode AUE1 may be connected to a common electrode auxiliary electrode VCE. Accordingly, the vertical voltage line VVSL may supply a low potential voltage to the common electrode CME.

The vertical voltage line VVSL may be connected to the second voltage line VSL to supply a low potential voltage to the second voltage line VSL.

The second voltage line VSL may extend in the first direction DR1. The second voltage line VSL may be disposed on the lower side of the second gate line GL2 in a plan view. The second voltage line VSL may be disposed in a second metal layer MTL2. The second voltage line VSL may receive a low potential voltage from the vertical voltage line VVSL.

The first gate line GL1 may be disposed on the upper side of the pixel circuit of the first pixel SP1 in a plan view. The first gate line GL1 may be disposed at (e.g., in or on) the second metal layer MTL2. The first gate line GL1 may include the first auxiliary gate line BGL1-1 branched at the first branch point BRP1-1, and the second auxiliary gate line BGL1-2 branched at the second branch point BRP1-2.

The first auxiliary gate line BGL1-1 may be branched at the first branch point BRP1-1. The first branch point BRP1-1 may be disposed on the right side of the first voltage line VDL. The first auxiliary gate line BGL1-1 may be branched on the right side of the first voltage line VDL, and may extend in the direction opposite to the second direction DR2 to protrude from the first branch point BRP1-1. The first auxiliary gate line BGL1-1 may be disposed between the first voltage line VDL and the first capacitor C1 of the first pixel SP1 in a plan view. The first gate line GL1 may supply the first gate signal to the second transistor ST2 of the first pixel SP1 through the first auxiliary gate line BGL1-1.

The second auxiliary gate line BGL1-2 may be branched at the second branch point BRP1-2. The second branch point BRP1-2 may be disposed on the left side of the second data line DL2. The second auxiliary gate line BGL1-2 may be branched on the left side of the second data line DL2, and may extend in the direction opposite to the second direction DR2 to protrude from the second branch point BRP1-2. The second auxiliary gate line BGL1-2 may be disposed between the second data line DL2 and the first capacitor C1 of the first pixel SP1 in a plan view. The first gate line GL1 may supply the first gate signal to the second transistor ST2 of each of the second and third pixels SP2 and SP3 through the second auxiliary gate line BGL1-2.

The second gate line GL2 may be disposed on the lower side of the pixel circuit of the third pixel SP3 in a plan view. The second gate line GL2 may be disposed at (e.g., in or on) the second metal layer MTL2. The second gate line GL2 may include the third auxiliary gate line BGL2 branched at the third branch point BRP2.

The third auxiliary gate line BGL2 may be branched at the third branch point BRP2. The third branch point BRP2 may be disposed on the left side of the first voltage line VDL. The third auxiliary gate line BGL2 may be branched on the left side of the first voltage line VDL, and may extend in the direction opposite to the second direction DR2 to protrude from the third branch point BRP2. The third auxiliary gate line BGL2 may be disposed between the first voltage line VDL and the initialization voltage line VIL in a plan view. The second gate line GL2 may supply the second gate signal to the third transistor ST3 of each of the first to third pixels SP1, SP2, and SP3 through the third auxiliary gate line BGL2.

The data lines DL may include the first to third data lines DL1, DL2, and DL3. Each of the first to third data lines DL1, DL2, and DL3 may extend in the second direction DR2.

The first data line DL1 may be disposed on the left side of the vertical voltage line VVSL in a plan view. The first data line DL1 may be disposed in the first metal layer MTL1. The first data line DL1 may overlap with a second connection electrode CE2 of the second metal layer MTL2.

The second connection electrode CE2 may extend in the first direction DR1. The second connection electrode CE2 may be disposed at (e.g., in or on) the second metal layer MTL2. The second connection electrode CE2 may be disposed below the first gate line GL1. The second connection electrode CE2 may be disposed above the first and second auxiliary electrodes AUE1 and AUE2 and the first connection electrode CE1.

The second connection electrode CE2 may electrically connect the first data line DL1 to the second drain electrode DE2 of the second transistor ST2 of the first pixel SP1. Accordingly, the first data line DL1 may supply a data voltage to the second transistor ST2 of the first pixel SP1 through the second connection electrode CE2.

In the display device 10, because the first auxiliary gate line BGL1-1 is disposed on the right side of the first voltage line VDL, the second transistor ST2 of the first pixel SP1 may be disposed on the right side of the first voltage line VDL. Furthermore, because the first data line DL1 is disposed on the left side of the vertical voltage line VVSL, or in other words, on the leftmost side in the unit pixel USP, the second connection electrode CE2 connecting the second transistor ST2 to the first data line DL1 may overlap with at least one of the first data line DL1, the vertical voltage line VVSL, the initialization voltage line VIL, or the first voltage line VDL.

The second data line DL2 may be disposed on the right side of the first auxiliary gate line BGL1-1 in a plan view. The second data line DL2 may be disposed in the first metal layer MTL1. The second data line DL2 may overlap with the fifth connection electrode CE5 of the second metal layer MTL2.

The fifth connection electrode CE5 may extend in a direction opposite to the first direction DR1. The fifth connection electrode CE5 may be disposed at (e.g., in or on) the second metal layer MTL2. The fifth connection electrode CE5 may electrically connect the second data line DL2 to the second drain electrode DE2 of the second transistor ST2 of the second pixel SP2. Accordingly, the second data line DL2 may supply a data voltage to the second transistor ST2 of the second pixel SP2 through the fifth connection electrode CE5.

The third data line DL3 may be disposed on the right side of the second data line DL2 in a plan view. The third data line DL3 may be disposed in the first metal layer MTL1. The third data line DL3 may overlap with the seventh connection electrode CE7 of the second metal layer MTL2.

The seventh connection electrode CE7 may extend in the direction opposite to the first direction DR1. The seventh connection electrode CE7 may be disposed at (e.g., in or on) the second metal layer MTL2. The seventh connection electrode CE7 may electrically connect the third data line DL3 to the second drain electrode DE2 of the second transistor ST2 of the third pixel SP3. Accordingly, the third data line DL3 may supply a data voltage to the second transistor ST2 of the third pixel SP3 through the seventh connection electrode CE7.

The pixel circuit of the first pixel SP1 may include first to third transistors ST1, ST2, and ST3.

The first transistor ST1 of the first pixel SP1 may include a first active region ACT1, a first upper gate electrode UGE1, a first lower gate electrode BGE1, the first drain electrode DE1, and the first source electrode SE1.

The first active region ACT1 of the first transistor ST1 may be disposed at (e.g., in or on) the active layer ACTL, and may overlap with the first upper gate electrode UGE1 of the first transistor ST1.

The first upper gate electrode UGE1 of the first transistor ST1 may be disposed at (e.g., in or on) the second metal layer MTL2. The first upper gate electrode UGE1 of the first transistor ST1 may be connected to the first capacitor electrode CPE1 of the first capacitor C1 at one end thereof in the first direction DR1. The first upper gate electrode UGE1 of the first transistor ST1 may be connected to the second source electrode SE2 of the second transistor ST2 at the other end thereof in the first direction DR1.

The first lower gate electrode BGE1 of the first transistor ST1 may be disposed at (e.g., in or on) the first metal layer MTL1. The first lower gate electrode BGE1 of the first transistor ST1 may be connected to the third connection electrode CE3. The first lower gate electrode BGE1 of the first transistor ST1 may be electrically connected to the first source electrode SE1 of the first transistor ST1 and the third drain electrode DE3 of the third transistor ST3 through the third connection electrode CE3. In other words, the first lower gate electrode BGE1 of the first transistor ST1 may be electrically connected to the second node N2.

The first drain electrode DE1 and the first source electrode SE1 of the first transistor ST1 may be made conductive by heat treatment of the active layer ACTL. The first drain electrode DE1 and the first source electrode SE1 of the first transistor ST1 may be made conductive as an N-type semiconductor, but the present disclosure is not limited thereto.

The first drain electrode DE1 of the first transistor ST1 may be electrically connected to the first voltage line VDL through the first connection electrode CE1. The first connection electrode CE1 may be connected to the first voltage line VDL1. Accordingly, the first drain electrode DE1 of the first transistor ST1 may receive the driving voltage from the first voltage line VDL.

The first source electrode SE1 of the first transistor ST1 may be a part of the second capacitor electrode CPE2 of the first capacitor C1. Accordingly, the first capacitor C1 may be formed between the first source electrode SE1 of the first transistor ST1, which is the second capacitor electrode CPE2, and the first capacitor electrode CPE1.

The first source electrode SE1 (or the first capacitor electrode CPE1) of the first transistor ST1 may be electrically connected to the light emitting element ED of the first pixel SP1. In other words, the first source electrode SE1 of the first transistor ST1 may be electrically connected to a first pixel electrode PXR of the third metal layer MTL3. Accordingly, the first source electrode SE1 of the first transistor ST1 may supply a driving current to the light emitting element ED.

The second transistor ST2 of the first pixel SP1 may include a second active region ACT2, a second gate electrode GE2, a second drain electrode DE2, and a second source electrode SE2.

The second active region ACT2 of the second transistor ST2 may be disposed at (e.g., in or on) the active layer ACTL, and may overlap with the second gate electrode GE2 of the second transistor ST2.

The second gate electrode GE2 of the second transistor ST2 may be disposed in the second metal layer MTL2. The second gate electrode GE2 of the second transistor ST2 may be a part of the first auxiliary gate line BGL1-1 of the first gate line GL1.

The second drain electrode DE2 and the second source electrode SE2 of the second transistor ST2 may be made conductive by heat treatment of the active layer ACTL. The second drain electrode DE2 and the second source electrode SE2 of the second transistor ST2 may be made conductive as an N-type semiconductor, but the present disclosure is not limited thereto.

The second drain electrode DE2 of the second transistor ST2 may be connected to the second connection electrode CE2 of the second metal layer MTL2. The second drain electrode DE2 of the second transistor ST2 may be electrically connected to the first data line DL1 through the second connection electrode CE2 of the second metal layer MTL2. Accordingly, the first data line DL1 may supply a data voltage to the second transistor ST2 of the first pixel SP1 through the second connection electrode CE2.

The second source electrode SE2 of the second transistor ST2 may be connected to the first upper gate electrode UGE1 of the first transistor ST1. Accordingly, the second source electrode SE2 of the second transistor ST2 may supply a first gate voltage to the first transistor ST1.

In the display device 10, the second transistor ST2 of the first pixel SP1 may be disposed on the right side of the first voltage line VDL. For example, the second transistor ST2 of the first pixel SP1 may be disposed on the left side of the first capacitor C1 of the first pixel SP1. Accordingly, even if the end of a second pixel electrode PXG of the second pixel SP2 to be described in more detail below extends in the first direction DR1 and the second direction DR2, it may not overlap with the second transistor ST2 of the first pixel SP1 or the first upper gate electrode UGE1 of the first transistor ST1 of the first pixel SP1. Therefore, a coupling phenomenon between the first upper gate electrode UGE1 of the first transistor ST1 of the first pixel SP1 and the second pixel electrode PXG of the second pixel SP2 may be minimized or reduced, so that a color difference that might be caused by the coupling phenomenon may be minimized or reduced. In addition, as the end of the second pixel electrode PXG of the second pixel SP2 is extended, a color cast phenomenon in which a color other than white or black is displayed at a boundary between white and black may be minimized or reduced, and an opening ratio may be improved.

The third transistor ST3 of the first pixel SP1 may include the third active region ACT3, the third gate electrode GE3, the third drain electrode DE3, and the third source electrode SE3.

The third active region ACT3 of the third transistor ST3 may be disposed at (e.g., in or on) the active layer ACTL, and may overlap with the third gate electrode GE3 of the third transistor ST3.

The third gate electrode GE3 of the third transistor ST3 may be disposed in the second metal layer MTL2. The third gate electrode GE3 of the third transistor ST3 may be a part of the third auxiliary gate line BGL2 of the second gate line GL2.

The third drain electrode DE3 and the third source electrode SE3 of the third transistor ST3 may be made conductive by heat treatment of the active layer ACTL. The third drain electrode DE3 and the third source electrode SE3 of the third transistor ST3 may be made conductive as an N-type semiconductor, but the present disclosure is not limited thereto.

The third drain electrode DE3 of the third transistor ST3 may be electrically connected to the first source electrode SE1 of the first transistor ST1 and the second capacitor electrode CPE2 of the first capacitor C1. The third drain electrode DE3 of the third transistor ST3 may be connected to the third connection electrode CE3 of the second metal layer MTL2. The third drain electrode DE3 of the third transistor ST3 may be electrically connected to the first lower gate electrode BGE1 of the first transistor ST1 through the third connection electrode CE3.

The third source electrode SE3 of the third transistor ST3 may be connected to the second auxiliary electrode AUE2 of the second metal layer MTL2. The third source electrode SE3 of the third transistor ST3 may be electrically connected to the initialization voltage line VIL through the second auxiliary electrode AUE2. The third source electrode SE3 of the third transistor ST3 may receive the initialization voltage from the initialization voltage line VIL. The third source electrode SE3 of the third transistor ST3 may supply the sensing signal to the initialization voltage line VIL.

The pixel circuit of the second pixel SP2 may include first to third transistors ST1, ST2, and ST3.

The first transistor ST1 of the second pixel SP2 may include the first active region ACT1, the first upper gate electrode UGE1, the first lower gate electrode BGE1, the first drain electrode DE1, and the first source electrode SE1.

The first active region ACT1 of the first transistor ST1 may be disposed at (e.g., in or on) the active layer ACTL, and may overlap with the first upper gate electrode UGE1 of the first transistor ST1.

The first upper gate electrode UGE1 of the first transistor ST1 may be disposed at (e.g., in or on) the second metal layer MTL2. The first upper gate electrode UGE1 of the first transistor ST1 may be connected to the first capacitor electrode CPE1 of the first capacitor C1 and the second source electrode SE2 of the second transistor ST2 through the extension portion.

The first lower gate electrode BGE1 of the first transistor ST1 may be disposed at (e.g., in or on) the first metal layer MTL1. The first lower gate electrode BGE1 of the first transistor ST1 may be connected to the sixth connection electrode CE6. The first lower gate electrode BGE1 of the first transistor ST1 may be electrically connected to the first source electrode SE1 of the first transistor ST1 and the third drain electrode DE3 of the third transistor ST3 through the sixth connection electrode CE6. In other words, the first lower gate electrode BGE1 of the first transistor ST1 may be electrically connected to the second node N2.

The first drain electrode DE1 and the first source electrode SE1 of the first transistor ST1 may be made conductive by heat treatment of the active layer ACTL. The first drain electrode DE1 and the first source electrode SE1 of the first transistor ST1 may be made conductive as an N-type semiconductor, but the present disclosure is not limited thereto.

The first drain electrode DE1 of the first transistor ST1 may be electrically connected to the first voltage line VDL through a drain connection portion DCP and the fourth connection electrode CE4. The fourth connection electrode CE4 may be connected to the first voltage line VDL. The drain connection portion DCP may be connected to the fourth connection electrode CE4. The drain connection portion DCP may be disposed between the first drain electrode DE1 of the first transistor ST1 of the second pixel SP2 and the first drain electrode DE1 of the first transistor ST1 of the third pixel SP3, and may supply a driving voltage to each of the two first drain electrodes DE1. Accordingly, the first drain electrode DE1 of the first transistor ST1 may receive the driving voltage from the first voltage line VDL through the drain connection portion DCP and the fourth connection electrode CE4.

The first source electrode SE1 of the first transistor ST1 may be a part of the second capacitor electrode CPE2 of the first capacitor C1. Accordingly, the first capacitor C1 may be formed between the first source electrode SE1 of the first transistor ST1, which is the second capacitor electrode CPE2, and the first capacitor electrode CPE1.

The first source electrode SE1 (or the first capacitor electrode CPE1) of the first transistor ST1 may be electrically connected to the light emitting element ED of the second pixel SP2. In other words, the first source electrode SE1 of the first transistor ST1 may be electrically connected to the second pixel electrode PXG of the third metal layer MTL3. Accordingly, the first source electrode SE1 of the first transistor ST1 may supply a driving current to the light emitting element ED.

The second transistor ST2 of the second pixel SP2 may include a second active region ACT2, a second gate electrode GE2, a second drain electrode DE2, and a second source electrode SE2.

The second active region ACT2 of the second transistor ST2 may be disposed at (e.g., in or on) the active layer ACTL, and may overlap with the second gate electrode GE2 of the second transistor ST2.

The second gate electrode GE2 of the second transistor ST2 may be disposed in the second metal layer MTL2. The second gate electrode GE2 of the second transistor ST2 may be a part of the second auxiliary gate line BGL1-2 of the first gate line GL1.

The second drain electrode DE2 and the second source electrode SE2 of the second transistor ST2 may be made conductive by heat treatment of the active layer ACTL. The second drain electrode DE2 and the second source electrode SE2 of the second transistor ST2 may be made conductive as an N-type semiconductor, but the present disclosure is not limited thereto.

The second drain electrode DE2 of the second transistor ST2 may be connected to the fifth connection electrode CE5 of the second metal layer MTL2. The second drain electrode DE2 of the second transistor ST2 may be electrically connected to the second data line DL2 through the fifth connection electrode CE5 of the second metal layer MTL2. Accordingly, the second data line DL2 may supply a data voltage to the second transistor ST2 of the second pixel SP2 through the fifth connection electrode CE5.

The second source electrode SE2 of the second transistor ST2 may be connected to the extension portion of the first upper gate electrode UGE1 of the first transistor ST1. Accordingly, the second source electrode SE2 of the second transistor ST2 may supply the first gate voltage to the first transistor ST1. The second source electrode SE2 of the second transistor ST2 may be connected to the first capacitor electrode CPE1 of the first capacitor C1 through the extension portion of the first upper gate electrode UGE1 of the first transistor ST1.

In the display device 10, the second transistor ST2 of the second pixel SP2 may be disposed on the left side of the second data line DL2, unlike the second transistor ST2 of the first pixel SP1. For example, the second transistor ST2 of the second pixel SP2 may be disposed on the right side of the first capacitor C1 of the second pixel SP2.

The third transistor ST3 of the second pixel SP2 may include a third active region ACT3, a third gate electrode GE3, a third drain electrode DE3, and a third source electrode SE3.

The third active region ACT3 of the third transistor ST3 may be disposed at (e.g., in or on) the active layer ACTL, and may overlap with the third gate electrode GE3 of the third transistor ST3.

The third gate electrode GE3 of the third transistor ST3 may be disposed in the second metal layer MTL2. The third gate electrode GE3 of the third transistor ST3 may be a part of the third auxiliary gate line BGL2 of the second gate line GL2.

The third drain electrode DE3 and the third source electrode SE3 of the third transistor ST3 may be made conductive by heat treatment of the active layer ACTL. The third drain electrode DE3 and the third source electrode SE3 of the third transistor ST3 may be made conductive as an N-type semiconductor, but the present disclosure is not limited thereto.

The third drain electrode DE3 of the third transistor ST3 may be electrically connected to the first source electrode SE1 of the first transistor ST1 and the second capacitor electrode CPE2 of the first capacitor C1. The third drain electrode DE3 of the third transistor ST3 may be connected to the sixth connection electrode CE6. The third drain electrode DE3 of the third transistor ST3 may be electrically connected to the first lower gate electrode BGE1 of the first transistor ST1 through the sixth connection electrode CE6.

The third source electrode SE3 of the third transistor ST3 may be connected to the second auxiliary electrode AUE2 of the second metal layer MTL2. The third source electrode SE3 of the third transistor ST3 may be electrically connected to the initialization voltage line VIL through the second auxiliary electrode AUE2. The third source electrode SE3 of the third transistor ST3 may receive the initialization voltage from the initialization voltage line VIL. The third source electrode SE3 of the third transistor ST3 may supply the sensing signal to the initialization voltage line VIL.

The pixel circuit of the third pixel SP3 may include first to third transistors ST1, ST2, and ST3.

The first transistor ST1 of the third pixel SP3 may include the first active region ACT1, the first upper gate electrode UGE1, the first lower gate electrode BGE1, the first drain electrode DE1, and the first source electrode SE1.

The first active region ACT1 of the first transistor ST1 may be disposed at (e.g., in or on) the active layer ACTL, and may overlap with the first upper gate electrode UGE1 of the first transistor ST1.

The first upper gate electrode UGE1 of the first transistor ST1 may be disposed at (e.g., in or on) the second metal layer MTL2. The first upper gate electrode UGE1 of the first transistor ST1 may be connected to the first capacitor electrode CPE1 of the first capacitor C1 and the second source electrode SE2 of the second transistor ST2 through the extension portion.

The first lower gate electrode BGE1 of the first transistor ST1 may be disposed at (e.g., in or on) the first metal layer MTL1. The first lower gate electrode BGE1 of the first transistor ST1 may be connected to the eighth connection electrode CE8. The first lower gate electrode BGE1 of the first transistor ST1 may be electrically connected to the first source electrode SE1 of the first transistor ST1 and the third drain electrode DE3 of the third transistor ST3 through the eighth connection electrode CE8. In other words, the first lower gate electrode BGE1 of the first transistor ST1 may be electrically connected to the second node N2.

The first drain electrode DE1 and the first source electrode SE1 of the first transistor ST1 may be made conductive by heat treatment of the active layer ACTL. The first drain electrode DE1 and the first source electrode SE1 of the first transistor ST1 may be made conductive as an N-type semiconductor, but the present disclosure is not limited thereto.

The first drain electrode DE1 of the first transistor ST1 may be electrically connected to the first voltage line VDL through a drain connection portion DCP and the fourth connection electrode CE4. The fourth connection electrode CE4 may be connected to the first voltage line VDL. The drain connection portion DCP may be connected to the fourth connection electrode CE4. The drain connection portion DCP may be disposed between the first drain electrode DE1 of the first transistor ST1 of the second pixel SP2 and the first drain electrode DE1 of the first transistor ST1 of the third pixel SP3, and may supply a driving voltage to each of the two first drain electrodes DE1. Accordingly, the first drain electrode DE1 of the first transistor ST1 may receive the driving voltage from the first voltage line VDL through the drain connection portion DCP and the fourth connection electrode CE4.

The first source electrode SE1 of the first transistor ST1 may be a part of the second capacitor electrode CPE2 of the first capacitor C1. Accordingly, the first capacitor C1 may be formed between the first source electrode SE1 of the first transistor ST1, which is the second capacitor electrode CPE2, and the first capacitor electrode CPE1.

The first source electrode SE1 (or the first capacitor electrode CPE1) of the first transistor ST1 may be electrically connected to the light emitting element ED of the third pixel SP3. In other words, the first source electrode SE1 of the first transistor ST1 may be electrically connected to a third pixel electrode PXB of the third metal layer MTL3. Accordingly, the first source electrode SE1 of the first transistor ST1 may supply a driving current to the light emitting element ED.

The second transistor ST2 of the third pixel SP3 may include a second active region ACT2, a second gate electrode GE2, a second drain electrode DE2, and a second source electrode SE2.

The second active region ACT2 of the second transistor ST2 may be disposed at (e.g., in or on) the active layer ACTL, and may overlap with the second gate electrode GE2 of the second transistor ST2.

The second gate electrode GE2 of the second transistor ST2 may be disposed in the second metal layer MTL2. The second gate electrode GE2 of the second transistor ST2 may be a part of the second auxiliary gate line BGL1-2 of the first gate line GL1.

The second drain electrode DE2 and the second source electrode SE2 of the second transistor ST2 may be made conductive by heat treatment of the active layer ACTL. The second drain electrode DE2 and the second source electrode SE2 of the second transistor ST2 may be made conductive as an N-type semiconductor, but the present disclosure is not limited thereto.

The second drain electrode DE2 of the second transistor ST2 may be connected to the seventh connection electrode CE7 of the second metal layer MTL2. The second drain electrode DE2 of the second transistor ST2 may be electrically connected to the third data line DL3 through the seventh connection electrode CE7 of the second metal layer MTL2. Accordingly, the third data line DL3 may supply a data voltage to the second transistor ST2 of the third pixel SP3 through the seventh connection electrode CE7.

The second source electrode SE2 of the second transistor ST2 may be connected to the extension portion of the first upper gate electrode UGE1 of the first transistor ST1. Accordingly, the second source electrode SE2 of the second transistor ST2 may supply the first gate voltage to the first transistor ST1. The second source electrode SE2 of the second transistor ST2 may be connected to the first capacitor electrode CPE1 of the first capacitor C1 through the extension portion of the first upper gate electrode UGE1 of the first transistor ST1.

In the display device 10, the second transistor ST2 of the third pixel SP3 may be disposed on the left side of the second data line DL2, unlike the second transistor ST2 of the first pixel SP1. For example, the second transistor ST2 of the third pixel SP3 may be disposed on the right side of the first capacitor C1 of the third pixel SP3.

The third transistor ST3 of the third pixel SP3 may include a third active region ACT3, a third gate electrode GE3, a third drain electrode DE3, and a third source electrode SE3.

The third active region ACT3 of the third transistor ST3 may be disposed at (e.g., in or on) the active layer ACTL, and may overlap with the third gate electrode GE3 of the third transistor ST3.

The third gate electrode GE3 of the third transistor ST3 may be disposed in the second metal layer MTL2. The third gate electrode GE3 of the third transistor ST3 may be a part of the third auxiliary gate line BGL2 of the second gate line GL2.

The third drain electrode DE3 and the third source electrode SE3 of the third transistor ST3 may be made conductive by heat treatment of the active layer ACTL. The third drain electrode DE3 and the third source electrode SE3 of the third transistor ST3 may be made conductive as an N-type semiconductor, but the present disclosure is not limited thereto.

The third drain electrode DE3 of the third transistor ST3 may be electrically connected to the first source electrode SE1 of the first transistor ST1 and the second capacitor electrode CPE2 of the first capacitor C1. The third drain electrode DE3 of the third transistor ST3 may be connected to the eighth connection electrode CE8. The third drain electrode DE3 of the third transistor ST3 may be electrically connected to the first lower gate electrode BGE1 of the first transistor ST1 through the eighth connection electrode CE8.

The third source electrode SE3 of the third transistor ST3 may be connected to the second auxiliary electrode AUE2 of the second metal layer MTL2. The third source electrode SE3 of the third transistor ST3 may be electrically connected to the initialization voltage line VIL through the second auxiliary electrode AUE2. The third source electrode SE3 of the third transistor ST3 may receive the initialization voltage from the initialization voltage line VIL. The third source electrode SE3 of the third transistor ST3 may supply the sensing signal to the initialization voltage line VIL.

The shielding electrode SHE may be disposed at (e.g., in or on) the second metal layer MTL2. The shielding electrode SHE may overlap with the first voltage line VDL. The shielding electrode SHE may extend in the first direction DR1. The shielding electrode SHE may be disposed between the first pixel SP1 and the second pixel SP2. For example, the shielding electrode SHE may be disposed between the third connection electrode CE3 and the sixth connection electrode CE6.

The shielding electrode SHE may receive a voltage having a potential different from that of the first capacitor electrode CPE1 of the first pixel SP1 and the first capacitor electrode CPE1 of the second pixel SP2. Accordingly, a coupling phenomenon may be minimized or reduced by blocking a voltage variation between the first capacitor electrode CPE1 of the first pixel SP1 and the first capacitor electrode CPE1 of the second pixel SP2.

The light emitting element layer EML may be disposed on the thin film transistor layer TFTL. The light emitting element layer EML may include the third metal layer MTL3 disposed on the passivation layer PV, a pixel defining layer PDL covering at least a part of the third metal layer MTL3, a light emitting layer LEL disposed on the third metal layer MTL3 and the pixel defining layer PDL, and a common electrode CME disposed on the light emitting layer LEL.

The third metal layer MTL3 may include a pixel electrode PXE and a common electrode auxiliary electrode VCE. The pixel electrode PXE may be a first electrode (e.g., an anode electrode) of a light emitting diode. The pixel electrode PXE may include the first pixel electrode PXR of the first pixel SP1, the second pixel electrode PXG of the second pixel SP2, and the third pixel electrode PXB of the third pixel SP3.

The first pixel electrode PXR of the first pixel SP1 may be disposed on or substantially on the left side of the pixel circuit of the first pixel SP1 in a plan view. For example, the first pixel electrode PXR may be generally disposed at an upper left end of the unit pixel USP. The first pixel electrode PXR may overlap with the vertical voltage line VVSL, the initialization voltage line VIL, and the first voltage line VDL in the third direction DR3. The first pixel electrode PXR may be disposed below the first gate line GL1.

The first pixel electrode PXR may be connected to the first source electrode SE1 of the first transistor ST1 of the first pixel SP1 through a contact hole. The first pixel electrode PXR may receive the driving voltage from the first voltage line VDL through the first source electrode SE1 of the first transistor ST1 of the first pixel SP1.

The second pixel electrode PXG of the second pixel SP2 may be disposed at or substantially at the center of the pixel circuit of the second pixel SP2 in a plan view. For example, the second pixel electrode PXG may be generally disposed at the center of the unit pixel USP. The second pixel electrode PXG may overlap with the first capacitor C1 of the first pixel SP1, the pixel circuit of the second pixel SP2, and the first lower gate electrode BGE1 of the third pixel SP3 in the third direction DR3. The second pixel electrode PXG may be disposed between the first pixel electrode PXR and the third pixel electrode PXB.

The second pixel electrode PXG may extend in a diagonal direction defined between the first direction DR1 and the second direction DR2. One end of the second pixel electrode PXG in the diagonal direction between the first direction DR1 and the second direction DR2 may overlap with the first capacitor C1 of the first pixel SP1 in the third direction DR3. The other end of the second pixel electrode PXG in the diagonal direction between the opposite direction of the first direction DR1 and the opposite direction of the second direction DR2 may overlap with the first voltage line VDL in the third direction DR3.

The second pixel electrode PXG may be connected to the first source electrode SE1 of the first transistor ST1 of the second pixel SP2 through a contact hole disposed at the center of the second pixel electrode PXG. The second pixel electrode PXG may receive the driving voltage from the first voltage line VDL through the first source electrode SE1 of the first transistor ST1 of the second pixel SP2.

The third pixel electrode PXB of the third pixel SP3 may be disposed on or substantially on the right side of the pixel circuit of the third pixel SP3 in a plan view. For example, the third pixel electrode PXB may be generally disposed at the right lower end of the unit pixel USP. The third pixel electrode PXB may overlap with the second and third data lines DL2 and DL3 and the first capacitor C1 of the third pixel SP3 in the third direction DR3.

The third pixel electrode PXB may extend in the first direction DR1. One end of the third pixel electrode PXB in the first direction DR1 may overlap with the second and third data lines DL2 and DL3. The other end of the third pixel electrode PXB in the first direction DR1 may overlap with the first capacitor C1 of the third pixel SP3.

The third pixel electrode PXB may be connected to the first source electrode SE1 of the first transistor ST1 of the third pixel SP3 through a contact hole adjacent to the other end of the third pixel electrode PXB in the first direction DR1. The third pixel electrode PXB may receive the driving voltage from the first voltage line VDL through the first source electrode SE1 of the first transistor ST1 of the third pixel SP3.

The common electrode auxiliary electrode VCE may be generally disposed at the lower left end of the unit pixel USP in a plan view. The common electrode auxiliary electrode VCE may overlap with the vertical voltage line VVSL, the initialization voltage line VIL, and the second gate line GL2.

The common electrode auxiliary electrode VCE may be connected to the first auxiliary electrode AUE1 through a contact hole disposed adjacent to one end thereof in the second direction DR2. The common electrode auxiliary electrode VCE may receive a low potential voltage from the vertical voltage line VVSL through the first auxiliary electrode AUE1.

The pixel defining layer PDL may be disposed on the third metal layer MTL3 and the passivation layer PV of the thin film transistor layer TFTL. The pixel defining layer PDL may electrically insulate the patterned third metal layer MTL3. The pixel defining layer PDL may include a plurality of open portions. Some of the plurality of open portions may expose a part of the third metal layer MTL3. The pixel electrode PXE of the third metal layer MTL3 may be in contact with the light emitting layer LEL through the plurality of open portions.

The emission area LA may be defined by the open portion of the pixel defining layer PDL. For example, the first emission area LA1 may be defined by the open portion of the pixel defining layer PDL overlapping with the first pixel electrode PXR, the second emission area LA2 may be defined by the open portion of the pixel defining layer PDL overlapping with the second pixel electrode PXG, and the third emission area LA3 may be defined by the open portion of the pixel defining layer PDL overlapping with the third pixel electrode PXB. The first to third emission areas LA1, LA2, and LA3 may have sizes smaller than those of the first to third pixel electrodes PXR, PXG, and PXB, respectively.

The first emission area LA1 may be generally disposed at the upper left end of the unit pixel USP in a plan view. The first emission area LA1 may overlap with most of the first pixel electrode PXR. The second emission area LA2 may be generally disposed at the center of the unit pixel USP in a plan view. The second emission area LA2 may overlap with most of the second pixel electrode PXG. The third emission area LA3 may be generally disposed at the lower right end of the unit pixel USP in a plan view. The third emission area LA3 may overlap with most of the third pixel electrode PXB.

Each of the contact holes through which a corresponding one of the first to third pixel electrodes PXR, PXG, and PXB is in contact with the first source electrode SE1 of the first transistor ST1 may not overlap with the open portion of the pixel defining layer PDL.

The light emitting layer LEL may be disposed on the third metal layer MTL3 and the pixel defining layer PDL. The light emitting layer LEL may be integrally disposed over the entire or substantially entire surface of the display area. The light emitting layer LEL may be physically connected to the emission area LA and the pixel SP. The light emitting layer LEL may be disposed across the emission area LA and the pixel SP. For example, the light emitting layer LEL may be in direct contact with the pixel electrode PXE exposed by the pixel defining layer PDL, and may also be in direct contact with the side and top surfaces of the pixel defining layer PDL. Accordingly, the wavelength of light emitted from the light emitting layer LEL may be the same or substantially the same for each of the emission areas LA1, LA2, and LA3. For example, the light emitting layer LEL of each of the emission areas LA1, LA2, and LA3 may emit blue light or ultraviolet light. In this case, a color control structure disposed above the light emitting element layer EML includes a wavelength conversion layer, and thus, a desired color for each pixel SP may be displayed.

In another implementation, a plurality of light emitting layers LEL may be spaced apart from each other, and a corresponding light emitting layer LEL may be disposed for each of the emission areas LA1, LA2, and LA3 distinguished by the pixel defining layer PDL. In this case, the wavelength of light emitted from each light emitting layer LEL may be different for each of the emission areas LA1, LA2, and LA3.

The common electrode CME may be arranged on the light emitting layer LEL. The common electrode CME may be integrally disposed over the entire or substantially the entire surface of the display area. The common electrode CME may be physically connected to the emission area LA and the pixel SP. The common electrode CME may be disposed across the emission area LA and the pixel SP. The common electrode CME may be a second electrode (e.g., a cathode electrode) of a light emitting diode.

The pixel electrode PXE, the light emitting layer LEL, and the common electrode CME may constitute a light emitting element (e.g., an OLED). Light emitted from the light emitting layer LEL may be emitted upward through the common electrode CME.

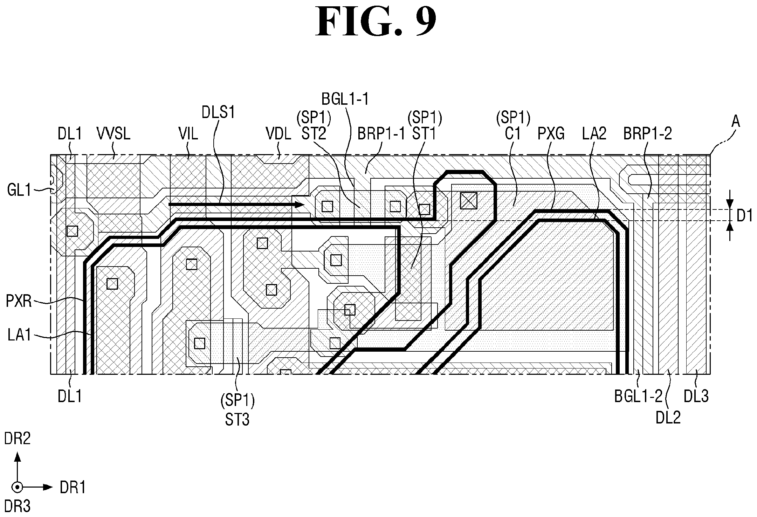

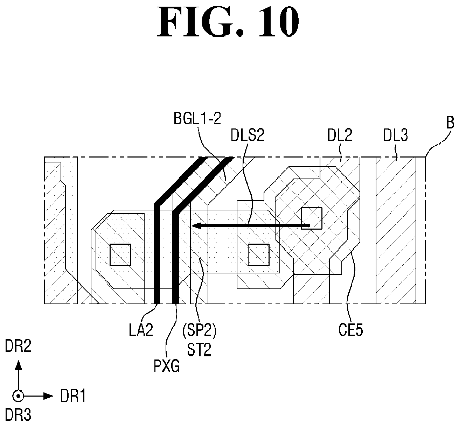

FIG. 9 is an enlarged view of the area A of FIG. 5. FIG. 10 is an enlarged view of the area B of FIG. 5.

Referring to FIGS. 5, 9, and 10, the second transistor ST2 of the first pixel SP1 may be disposed on the right side of the first voltage line VDL, and may be disposed on the left side of the first capacitor C1 of the first pixel SP1. The second transistor ST2 of the second pixel SP2 may be disposed on the right side of the first capacitor C1 of the second pixel SP2, and may be disposed on the left side of the second data line DL2. The second transistor ST2 of the third pixel SP3 may be disposed on the right side of the first capacitor C1 of the third pixel SP3, and may be disposed on the left side of the second data line DL2.

In the first pixel SP1, all of the first to third transistors ST1, ST2, and ST3 may be disposed on the right side of the initialization voltage line VIL, and may be disposed on the left side of the first capacitor C1 of the first pixel SP1.

A signal application direction of the first data line DL1 to the second transistor ST2 of the first pixel SP1 may be opposite to a signal application direction of the second and third data lines DL2 and DL3 to the second transistors ST2 of the second and third pixels SP2 and SP3. For example, the first data line DL1 may apply a first data signal DLS1 to the second transistor ST2 of the first pixel SP1 in the first direction DR1, the second data line DL2 may apply a second data signal DLS2 to the second transistor ST2 of the second pixel SP2 in the direction opposite to the first direction DR1, and the third data line DL3 may apply a third data signal to the second transistor ST2 of the third pixel SP3 in the direction opposite to the first direction DR1.

For example, because the first data line DL1 is disposed on the left side of the vertical voltage line VVSL, the second connection electrode CE2 may transmit the first data signal DLS1 from left to right in the drawing. Because the second and third data lines DL2 and DL3 are disposed on the right side of the second auxiliary gate line BGL1-2, the fifth and seventh connection electrodes CE5 and CE7 may transmit the second data signal DLS2 and the third data signal, respectively, from right to left in the drawing.

In the display device 10, the first to third transistors ST1, ST2, and ST3 of the first pixel SP1 are all disposed on the left side of the first capacitor C1. Thus, even if one end of the second pixel electrode PXG of the second pixel SP2 is further extended in the first direction DR1 and the second direction DR2, a coupling phenomenon between the first upper gate electrode UGE1 of the first transistor ST1 of the first pixel SP1 and the second pixel electrode PXG of the second pixel SP2 may be minimized or reduced, so that a color difference that might be caused by the coupling phenomenon may be minimized or reduced.

In addition, as the one end of the second pixel electrode PXG of the second pixel SP2 is extended, a distance D1 between one end of the first pixel electrode PXR and the one end of the second pixel electrode PXG in the second direction DR2 may be minimized or reduced. Accordingly, a color cast phenomenon in which a color other than white or black is displayed at a boundary between white and black may be minimized or reduced, and an opening ratio may be improved.

Further, the first pixel electrode PXR may not overlap with the second connection electrode CE2 in the third direction DR3. Accordingly, coupling of the first data signal DLS1 applied through the second connection electrode CE2 to the first pixel electrode PXR of the first pixel SP1 may be prevented or substantially prevented.

Other implementations of the display device may be described hereinafter. In the following implementations, the same or substantially the same (or similar) components as those described above are denoted with the same or like reference numerals, and thus, redundant description thereof may be simplified or not repeated, and differences may be mainly described hereinafter.

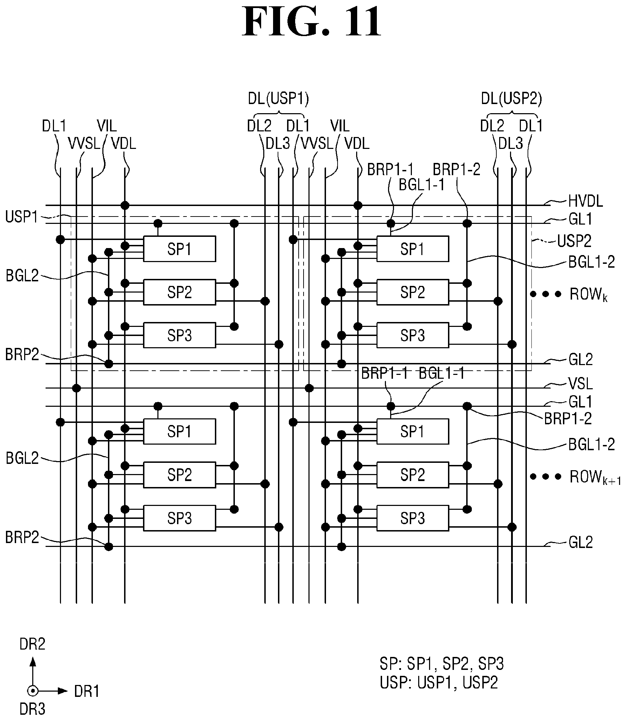

FIG. 11 is a diagram illustrating pixels and lines of a display device according to an embodiment.

Referring to FIG. 11, the described display device 10 may be different from the display device 10 described above with reference to FIG. 2 and the like in the layout of the unit pixel USP.

In more detail, in one unit pixel USP of the display device 10, the vertical voltage line VVSL may be disposed on the leftmost side, while the first data line DL1 may be disposed on the rightmost side. In other words, in one unit pixel USP, the data line DL may be disposed on the rightmost side.

In the display device 10, the first pixel SP1 of one unit pixel USP may be connected to the first data line DL1 passing through the other adjacent unit pixel USP. The first pixel SP1 of the one unit pixel USP may receive a data signal from the first data line DL1 passing through the other adjacent unit pixel USP.

For example, a first unit pixel USP1 and a second unit pixel USP2 disposed in the k^{th} row ROWk may be adjacent to each other in the first direction DR1. The first pixel SP1 of the second unit pixel USP2 may be connected to the first data line DL1 passing through the first unit pixel USP1. The first pixel SP1 of the second unit pixel USP2 may receive a data signal from the first data line DL1 passing through the first unit pixel USP1.

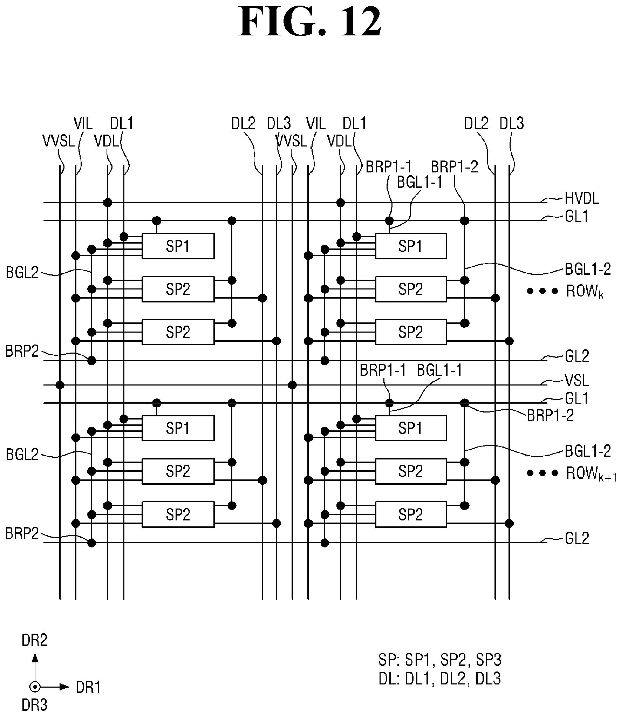

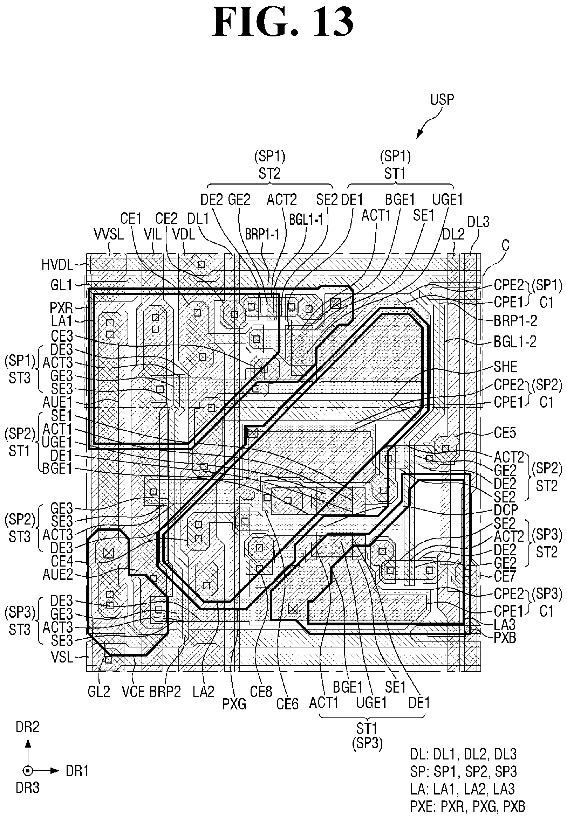

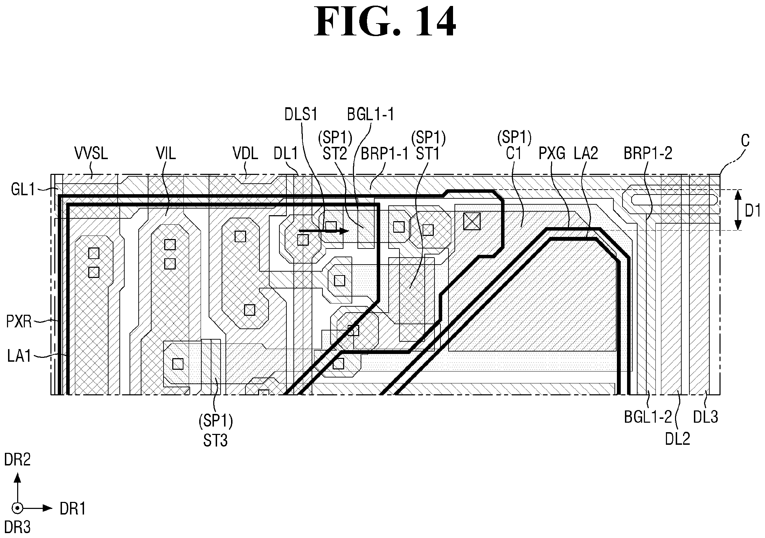

FIG. 12 is a diagram illustrating pixels and lines of a display device according to another implementation. FIG. 13 is a plan view illustrating a thin film transistor layer, a pixel electrode, and a pixel defining layer of a display device. FIG. 14 is an enlarged view of the area C of FIG. 13.

Referring to FIGS. 12 to 14, the described display device 10 may be different from the display device 10 described above with reference to FIG. 2 and the like, in that the first data line DL1 is disposed on the right side of the first voltage line VDL.

In more detail, in the display device 10 now described, the first data line DL1 may be disposed on the right side of the first voltage line VDL, and may be disposed on the left side of the first auxiliary gate line BGL1-1.

The second connection electrode CE2 may be disposed on the right side of the first voltage line VDL, and may be disposed on the left side of the first auxiliary gate line BGL1-1. The second connection electrode CE2 may be disposed on the right side of the first connection electrode CE1.

In the display device 10, the first to third transistors ST1, ST2, and ST3 of the first pixel SP1 are all disposed on the left side of the first capacitor C1. Thus, even if one end of the second pixel electrode PXG of the second pixel SP2 is further extended in the first direction DR1 and the second direction DR2, a color difference that might be caused by coupling between the first upper gate electrode UGE1 of the first transistor ST1 of the first pixel SP1 and the second pixel electrode PXG of the second pixel SP2 may be minimized or reduced.

In addition, as the one end of the second pixel electrode PXG of the second pixel SP2 is extended, the distance D1 between one end of the first pixel electrode PXR and the one end of the second pixel electrode PXG in the second direction DR2 may be minimized or reduced. Accordingly, a color cast phenomenon in which a color other than white or black is displayed at a boundary between white and black may be minimized or reduced, and an opening ratio may be improved.

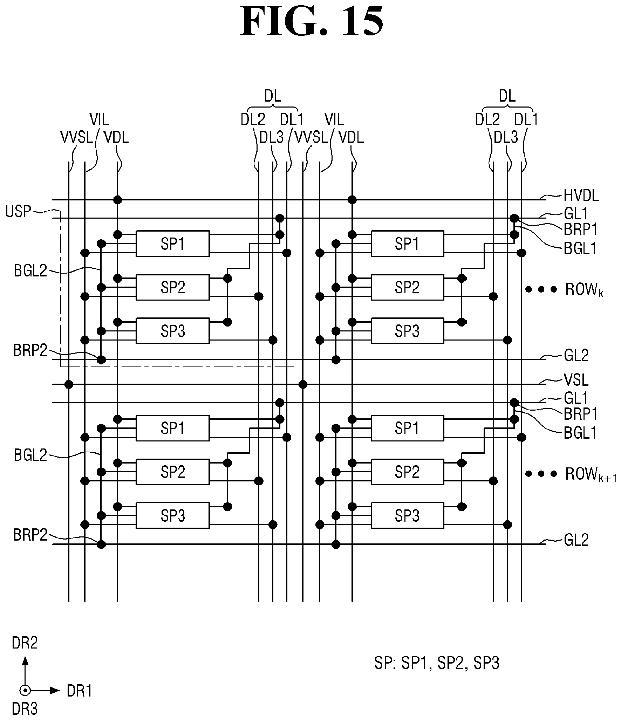

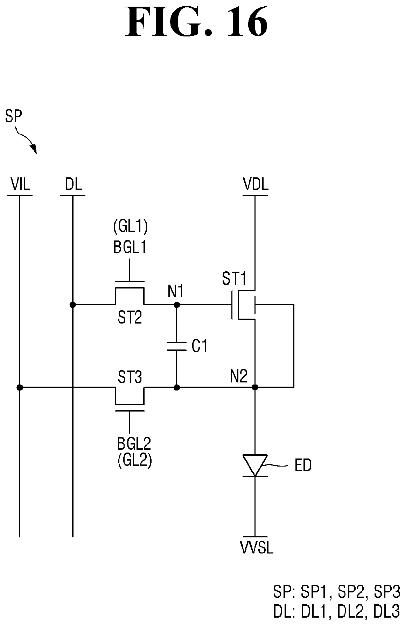

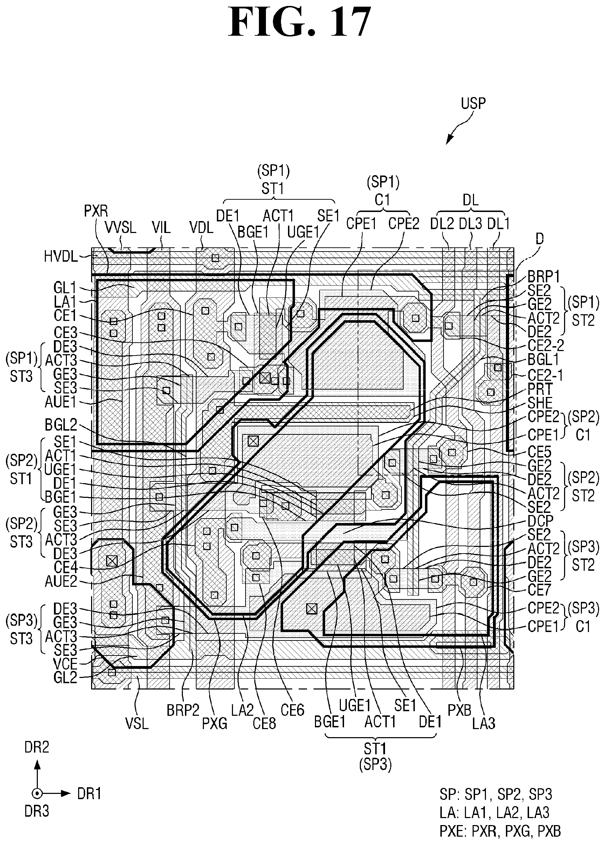

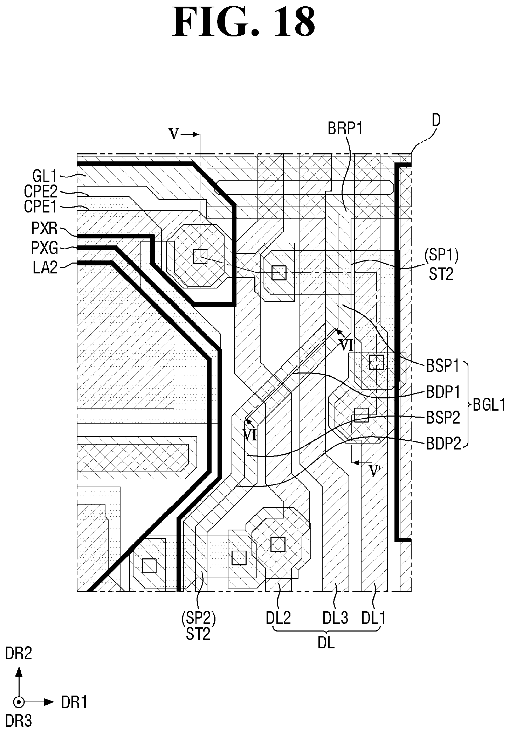

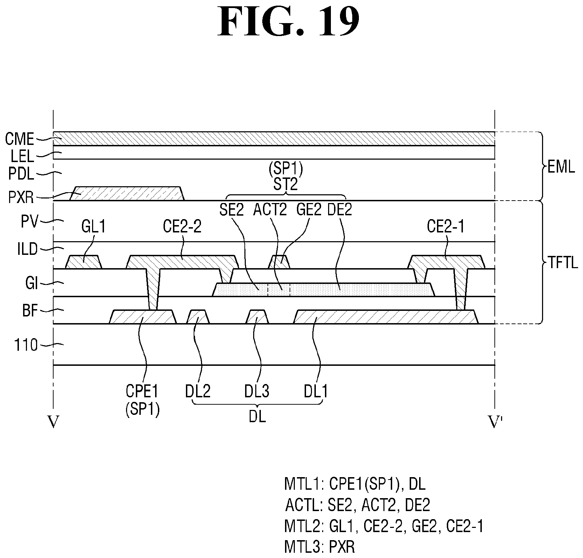

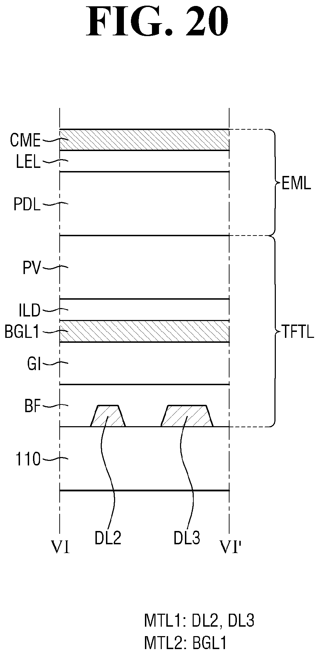

FIG. 15 is a diagram illustrating pixels and lines of a display device according to another implementation. FIG. 16 is a circuit diagram showing a pixel of a display device. FIG. 17 is a plan view illustrating a thin film transistor layer, a pixel electrode, and a pixel defining layer of a display device. FIG. 18 is an enlarged view of the area D of FIG. 17. FIG. 19 is a cross-sectional view taken along the line V-V' of FIG. 18. FIG. 20 is a cross-sectional view taken along the line VI-VI' of FIG. 18.

Referring to FIG. 15, the described display device 10 may be different from the display device 10 described above with reference to FIG. 2 and the like, in that the first data line DL1 is disposed on the rightmost side of the unit pixel USP, the first gate line GL1 is connected to one auxiliary gate line, and the position of a branch point is different.

In more detail, the first data line DL1 may be disposed on the rightmost side of the unit pixel USP. The first data line DL1 may be disposed on the right side of the third data line DL3.

The first gate line GL1 may include the first auxiliary gate line BGL1. The first gate line GL1 may supply the first gate signal received from the gate driver 260 to the first auxiliary gate line BGL1.

The first auxiliary gate line BGL1 may be branched from the first gate line GL1 at the first branch point BRP1, and extend in the direction opposite to the second direction DR2. The first branch point BRP1 may be disposed between the third data line DL3 and the first data line DL1. An initial portion of the first auxiliary gate line BGL1 may be disposed between the third data line DL3 and the first data line DL1. The first auxiliary gate line BGL1 may supply the first gate signal received from the first gate line GL1 to the pixel circuits of the first to third pixels SP1, SP2, and SP3.

Referring to FIG. 16, in each of the first to third pixels SP1, SP2, and SP3, the second transistor ST2 may be turned on by the first gate signal provided from the first auxiliary gate line BGL1 of the first gate line GL1 to electrically connect the data line DL to the first node N1, which is the upper gate electrode of the first transistor ST1. The gate electrode of the second transistor ST2 of each of the first to third pixels SP1, SP2, and SP3 may be connected to the first auxiliary gate line BGL1 of the first gate line GL1, and the drain electrode thereof may be connected to the data line DL.

Referring to FIGS. 16 to 20, the second metal layer MTL2 may include a second-first connection electrode CE2-1 and a second-second connection electrode CE2-2.

The second data line DL2 may be disposed on the right side of the first capacitors C1 of the first to third pixels SP1, SP2, and SP3 in a plan view.

The third data line DL3 may be disposed on the right side of the second data line DL2 in a plan view.

The first data line DL1 may be disposed on the right side of the third data line DL3 in a plan view. The first data line DL1 may overlap with the second-first connection electrode CE2-1.

The second-first connection electrode CE2-1 may extend in the second direction DR2. The second-first connection electrode CE2-1 may be disposed at (e.g., in or on) the second metal layer MTL2. The second-first connection electrode CE2-1 may be disposed on the right side of the first auxiliary gate line BGL1 and the third data line DL3. The second-first connection electrode CE2-1 may electrically connect the first data line DL1 to the second drain electrode DE2 of the second transistor ST2 of the first pixel SP1. Accordingly, the first data line DL1 may supply a data voltage to the second transistor ST2 of the first pixel SP1 through the second-first connection electrode CE2-1.

The first gate line GL1 may include the first auxiliary gate line BGL1 branched therefrom at the first branch point BRP1 in a plan view.

The first auxiliary gate line BGL1 may be branched at the first branch point BRP1. The first branch point BRP1 may be disposed between the third data line DL3 and the first data line DL1. The first auxiliary gate line BGL1 may be branched between the third data line DL3 and the first data line DL1, and may extend in the direction opposite to the second direction DR2 to protrude from the first branch point BRP1. The first gate line GL1 may supply the first gate signal to the second transistor ST2 of the first to third pixels SP1, SP2, and SP3 through the first auxiliary gate line BGL1.

The first auxiliary gate line BGL1 may include a straight portion extending parallel to or substantially parallel to the extension direction of the data line DL, and a bent portion extending in a direction different from the extension direction of the data line DL. The first auxiliary gate line BGL1 may include a first straight portion BSP1 extending from a main line of the first gate line GL1, a first bent portion BDP1 extending from the first straight portion BSP1, a second straight portion BSP2 extending from the first bent portion BDP1, and a second bent portion BDP2 extending from the second straight portion BSP2. The first bent portion BDP1 and the second bent portion BDP2 may extend in a direction different from that of the data line DL.

The first straight portion BSP1 may be disposed between the third data line DL3 and the first data line DL1 in a plan view. The first bent portion BDP1 may cross the third data line DL3 and the second data line DL2 in a plan view. The second straight portion BSP2 may be disposed on the left side of the second data line DL2 in a plan view. The second bent portion BDP2 may be disposed between the second data line DL2 and the second pixel electrode PXG in a plan view. The first bent portion BDP1 may overlap with the third data line DL3 and the second data line DL2 in the third direction DR3.

The second bent portion BDP2 may be spaced apart from the second pixel electrode PXG in a plan view. For example, the extension direction of the second bent portion BDP2 may be parallel to or substantially parallel to the extension direction of the end of the second pixel electrode PXG adjacent to the second bent portion BDP2.

In the display device 10, the first auxiliary gate line BGL1 may include a bent portion having a shape similar to that of the second pixel electrode PXG, so that it may not overlap with the second pixel electrode PXG. Accordingly, a coupling phenomenon between the first auxiliary gate line BGL1 and the second pixel electrode PXG may be prevented or substantially prevented.

The first upper gate electrode UGE1 of the first transistor ST1 of the first pixel SP1 may be connected to the first capacitor electrode CPE1 of the first capacitor C1 at one end in the first direction DR1.

The first capacitor electrode CPE1 of the first pixel SP1 may be connected to the second source electrode SE2 of the second transistor ST2 of the first pixel SP1 through the second-second connection electrode CE2-2.

The second-second connection electrode CE2-2 may extend in the direction opposite to the first direction DR1. The second-second connection electrode CE2-2 may be disposed in the second metal layer MTL2. The second-second connection electrode CE2-2 may be disposed on the left side of the third data line DL3. The second-second connection electrode CE2-2 may be disposed below the first gate line GL1. The second-second connection electrode CE2-2 may overlap with the second data line DL2 in the third direction DR3, and may cross the second data line DL2.

The second-second connection electrode CE2-2 may electrically connect the first capacitor electrode CPE1 of the first pixel SP1 to the second source electrode SE2 of the second transistor ST2 of the first pixel SP1. Therefore, in the first pixel SP1, the second transistor ST2 may be connected to the first upper gate electrode UGE1 of the first transistor ST1 through the second-second connection electrode CE2-2 to provide the data signal supplied from the first data line DL1 to the first transistor ST1.

The second gate electrode GE2 of the second transistor ST2 of the first pixel SP1 may be a part of the first auxiliary gate line BGL1 of the first gate line GL1. For example, the second gate electrode GE2 of the second transistor ST2 of the first pixel SP1 may be a part of the first straight portion BSP1 of the first auxiliary gate line BGL1. Accordingly, the second gate electrode GE2 of the second transistor ST2 of the first pixel SP1 may be disposed between the third data line DL3 and the first data line DL1.

The second drain electrode DE2 of the second transistor ST2 may be connected to the second-first connection electrode CE2-1. The second drain electrode DE2 of the second transistor ST2 may overlap with the first data line DL1 in the third direction DR3. The drain electrode DE2 of the second transistor ST2 may be electrically connected to the first data line DL1 through the second-first connection electrode CE2-1. Accordingly, the first data line DL1 may supply a data voltage to the second transistor ST2 of the first pixel SP1 through the second-first connection electrode CE2-1.

The second source electrode SE2 of the second transistor ST2 may be connected to the first capacitor electrode CPE1 of the first capacitor C1. Accordingly, the second source electrode SE2 of the second transistor ST2 may supply a first gate voltage to the first transistor ST1 through the first capacitor electrode CPE1.

In the display device 10, the second transistor ST2 of the first pixel SP1 may be disposed on the right side of the third data line DL3. For example, the second transistor ST2 of the first pixel SP1 may be disposed between the third data line DL3 and the first data line DL1. Accordingly, even if the end of the second pixel electrode PXG of the second pixel SP2 is extended in the first direction DR1 and the second direction DR2, it may not overlap with the second transistor ST2 of the first pixel SP1. Therefore, a coupling phenomenon between the second transistor ST2 of the first pixel SP1 and the second pixel electrode PXG of the second pixel SP2 may be minimized or reduced, so that a color difference may be minimized or reduced. In addition, as the end of the second pixel electrode PXG of the second pixel SP2 is extended, a color cast phenomenon in which a color other than white or black is displayed at a boundary between white and black may be minimized or reduced, and an opening ratio may be improved.

In some implementations, the first pixel electrode PXR of the first pixel SP1 may extend in the first direction DR1, and may overlap with the second-second connection electrode CE2-2 in the third direction DR3. In the display device 10 according to the present implementation, because the first pixel electrode PXR overlaps with the second-second connection electrode CE2-2, a coupling phenomenon between the second pixel electrode PXG and the second-second connection electrode CE2-2 may be minimized or reduced.

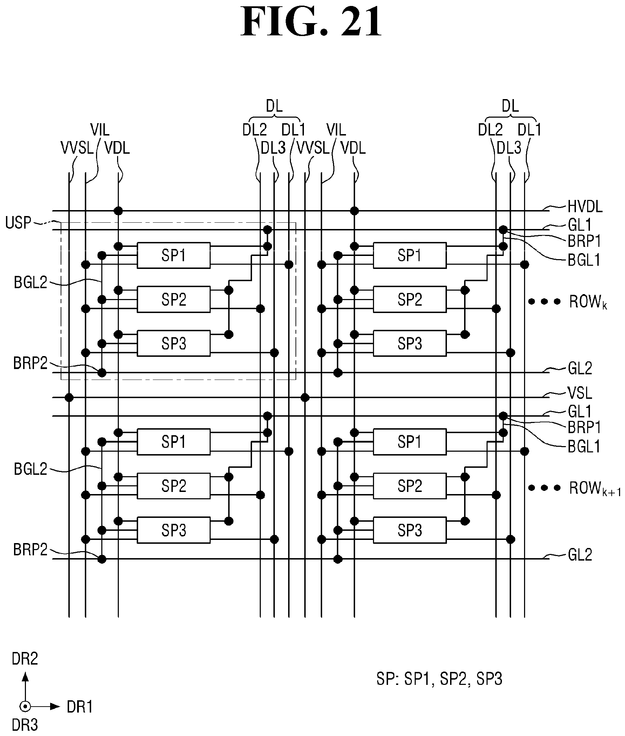

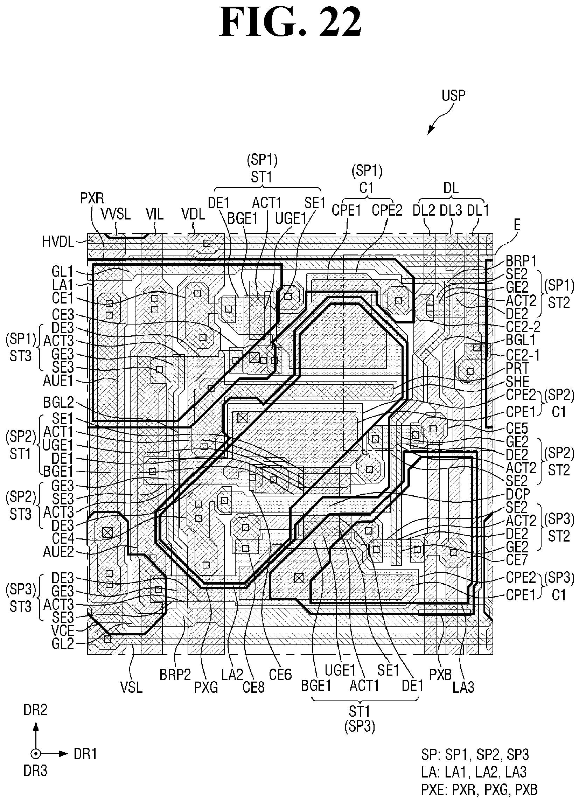

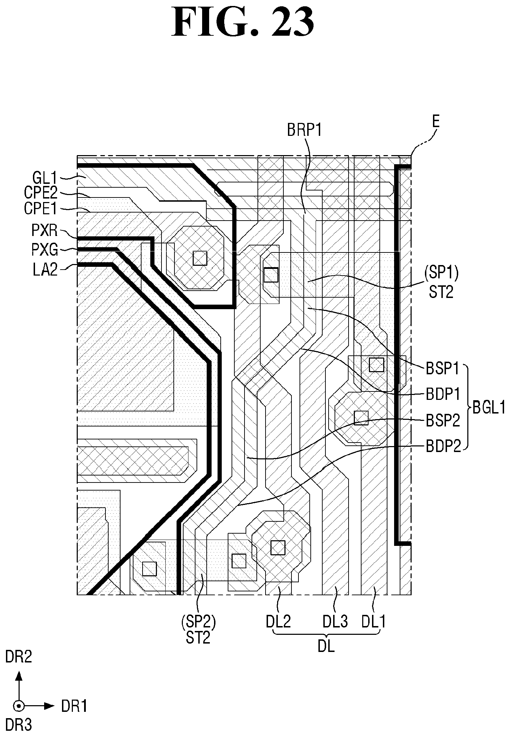

FIG. 21 is a diagram illustrating pixels and lines of a display device according to another implementation. FIG. 22 is a plan view illustrating a thin film transistor layer, a pixel electrode, and a pixel defining layer of a display device. FIG. 23 is an enlarged view of the area E of FIG. 17.

Referring to FIGS. 21 to 23, the described display device 10 according may be different from the display device 10 described above with reference to FIG. 15 and the like in the positions of the first branch point BRP1 and the first auxiliary gate line BGL1.

In more detail, the first branch point BRP1 may be disposed between the second data line DL2 and the third data line DL3. The first auxiliary gate line BGL1 may be branched between the second data line DL2 and the third data line DL3, and extend in the direction opposite to the second direction DR2 to protrude from the first branch point BRP1. The initial portion of the first auxiliary gate line BGL1 may be disposed between the second data line DL2 and the third data line DL3.

The first straight portion BSP1 may be disposed between the second data line DL2 and the third data line DL3 in a plan view. The first bent portion BDP1 may cross the second data line DL2 in a plan view. The second straight portion BSP2 may be disposed on the left side of the second data line DL2 in a plan view. The second bent portion BDP2 may be disposed between the second data line DL2 and the second pixel electrode PXG in a plan view. The first bent portion BDP1 may overlap with the second data line DL2 in the third direction DR3.

In the display device 10, the first auxiliary gate line BGL1 may include a bent portion having a shape similar to that of the second pixel electrode PXG, so that it may not overlap with the second pixel electrode PXG. Accordingly, a coupling phenomenon between the first auxiliary gate line BGL1 and the second pixel electrode PXG may be prevented or substantially prevented.

The second-second connection electrode CE2-2 may be disposed on the left side of the first auxiliary gate line BGL1.

The second gate electrode GE2 of the second transistor ST2 of the first pixel SP1 may be disposed between the second data line DL2 and the third data line DL3.

The second drain electrode DE2 of the second transistor ST2 may overlap with the third data line DL3 and the first data line DL1 in the third direction DR3.

In the display device 10, the second transistor ST2 of the first pixel SP1 may be disposed on the right side of the second data line DL2. For example, the second transistor ST2 of the first pixel SP1 may be disposed between the second data line DL2 and the third data line DL3. Accordingly, even if the end of the second pixel electrode PXG of the second pixel SP2 is extended in the first direction DR1 and the second direction DR2, it may not overlap with the second transistor ST2 of the first pixel SP1. Therefore, a coupling phenomenon between the second transistor ST2 of the first pixel SP1 and the second pixel electrode PXG of the second pixel SP2 may be minimized or reduced, so that a color difference may be minimized or reduced. In addition, as the end of the second pixel electrode PXG of the second pixel SP2 is extended, a color cast phenomenon in which a color other than white or black is displayed at a boundary between white and black may be minimized or reduced, and an opening ratio may be improved.

The first pixel electrode PXR of the first pixel SP1 may extend in the first direction DR1, and may overlap with the second-second connection electrode CE2-2 in the third direction DR3. In the display device 10 according to the present implementation, because the first pixel electrode PXR overlaps with the second-second connection electrode CE2-2, a coupling phenomenon between the second pixel electrode PXG and the second-second connection electrode CE2-2 may be minimized or reduced.

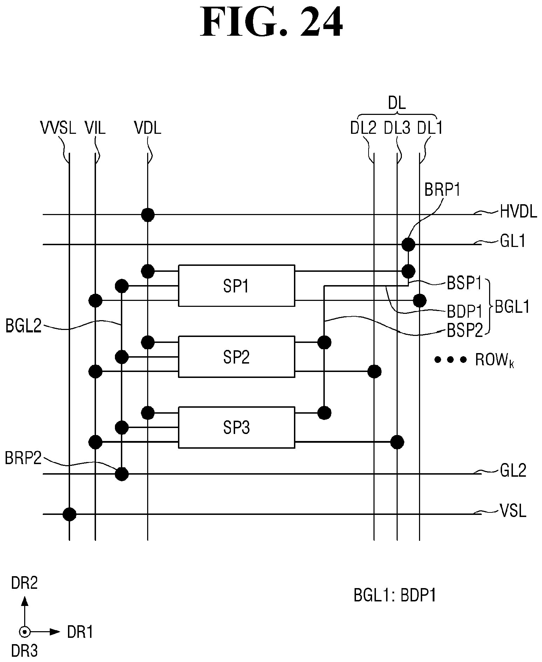

FIG. 24 is a diagram illustrating pixels and lines of a display device according to another implementation.

Referring to FIG. 24, the described display device 10 may be different from the display device 10 described above with reference to FIG. 15 and the like in the number of bent portions of the first auxiliary gate line BGL1.

In more detail, the first auxiliary gate line BGL1 may include a straight portion extending parallel to or substantially parallel to the extension direction of the data line DL, and a bent portion extending in a direction different from the extension direction of the data line DL. The first auxiliary gate line BGL1 may include a first straight portion BSP1 extending from a main line of the first gate line GL1, a first bent portion BDP1 extending from the first straight portion BSP1, and a second straight portion BSP2 extending from the first bent portion BSP1. The first bent portion BDP1 may extend in a direction different from that of the data line DL.

In FIG. 24, a case where the number of the bent portions is changed to one from the display device 10 described above with reference to FIG. 15 and the like is illustrated as an example. However, a case where the number of the bent portions is changed to one in the display device 10 described above with reference to FIG. 21 and the like may also be included as another example.

In the display device 10 according to the present implementation, the first auxiliary gate line BGL1 may include a bent portion having a shape similar to that of the second pixel electrode PXG, so that it may not overlap with the second pixel electrode PXG. Accordingly, a coupling phenomenon between the first auxiliary gate line BGL1 and the second pixel electrode PXG may be prevented or substantially prevented. In this case, as shown in FIGS. 15, 21, and 24, the number of the bent portions is not limited to one or two, but may have more than two, unless the first auxiliary gate line BGL1 overlaps with the second pixel electrode PXG.
The foregoing is illustrative of some embodiments of the present disclosure, and is not to be construed as limiting thereof. Although some embodiments have been described, those skilled in the art will readily appreciate that various modifications are possible in the embodiments without departing from the scope of the present invention as defined by the claims. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated.

## Claims

1. A display device comprising:
a first gate line (GL1); and
first and second auxiliary gate lines (BGL1-1, BGL1-2) protruding from the first gate line (GL1); and
first and second pixels (SP1, SP2), each comprising a first transistor (ST1) and a second transistor (ST2),
wherein the second transistor (ST2) of each of the first and second pixels comprises:
an active region (ACT2);
a drain electrode (DE2) on one side of the active region;
a source electrode (SE2) on the other side of the active region (ACT2); and
a gate electrode (GE2) overlapping with the active region (ACT2), and
wherein the gate electrodes (GE2) of the first and second pixels are respectively connected to the first and second auxiliary gate lines (BGL1-1, BGL1-2).

2. The display device of claim 1, wherein:
the first auxiliary gate line (BGL1-1) is located on one side of the first pixel; and
the second auxiliary gate line (BGL1-2) is located on another side of the first pixel.

3. The display device of claim 1 or 2, further comprising first and second data lines (DL1, DL2),
wherein the drain electrodes (DE2) of the second transistor (ST2) of the first and second pixels are respectively connected to the first and second data lines (DL1, DL2),
wherein the first data line (DL1) is located on one side of the first pixel, and
wherein the second data line (DL2) is located on an opposite side of the first pixel.

4. The display device of claim 3, wherein:
the first and second data lines (DL1, DL2) are configured to apply first and second data signals, respectively, to the second transistors (ST2) of the first and second pixels; and
the direction of a connection line from the first data line to the second transistor of the first pixel is opposite to the direction of a connection line from the second data line to the second transistor of the second pixel.

5. The display device of claim 3,
wherein each of the first and second pixels (SP1, SP2) further comprises a first capacitor electrode (CPE1), and
wherein an arrangement direction from the first capacitor electrode (CPE1) of the first pixel (SP1) to the second transistor of the first pixel (SP1) is opposite to an arrangement direction from the first capacitor electrode (CPE1) of the second pixel (SP2) to the second transistor of the second pixel (SP2).

6. The display device of claim 3, further comprising a first voltage line (VDL) on one side of the first auxiliary line (BGL1-1),
wherein the first transistor (ST1) of the first pixel comprises:
an active region (ACT1);
a drain electrode (DE1) on one side of the active region;
a source electrode (SE1) on the other side of the second active region; and
a gate electrode overlapping with the active region, and
wherein the drain electrode (DE1) of the first transistor (ST1) of the first pixel is connected to the first voltage line (VDL).

7. The display device of claim 6, wherein the first data line (DL1) is located on one side of the first voltage line (VDL).

8. The display device of claim 6, wherein the first auxiliary gate line (BGL1-1) is located between the first voltage line (VDL) and the second data line (DL2).

9. The display device of claim 6,
wherein the first pixel (SP1) further comprises a third transistor (ST3) and a first capacitor electrode (CPE1);
wherein the third transistor of the first pixel comprises:
an active region (ACT3);
a drain electrode (DE3) on one side of the active region;
a source electrode (SE3) on the other side of the active region; and
a gate electrode (GE3) overlapping with the active region; and
wherein the first to third transistors (ST1, ST2, ST3) of the first pixel (SP1) are located on the same side of the first capacitor electrode (CPE1).

10. The display device of claim 6, wherein:
the first pixel (SP1) further comprises a first pixel electrode (PXR) connected to the source electrode (SE1) of the first transistor (ST1) of the first pixel (SP1);
the first data line (DL1) and the drain electrode (DE2) of the second transistor (ST2) of the first pixel are connected to each other through a connection electrode CE2); and
the connection electrode (CE2) does not overlap with the first pixel electrode (PXR).

11. The display device of claim 10, further comprising at least one voltage line (VDL) between the first auxiliary gate line (BGL1-1) and the first data line (DL1),
wherein the connection electrode (CE2) overlaps with at least one of the at least one voltage line.

12. The display device of claim 3, wherein:
the second pixel (SP2) further comprises a second pixel electrode (PXG);
the first transistor (ST1) of the second pixel comprises:
an active region (ACT1);
a drain electrode (DE1) on one side of the active region;
a source electrode (SE1) on the other side of the active region; and
a gate electrode overlapping with the active region;
the second pixel electrode (PXG) is connected to the source electrode (SE1) of the first transistor (ST1) of the second pixel; and
the second pixel electrode (PXG) does not overlap with the second transistor (ST2) of the first pixel (SP1).

13. A display device comprising:
first and second data lines (DL1, DL2);
a first gate line (GL1), and an auxiliary gate line (BGL1) protruding from the first gate line (GL1); and
first and second pixels (SP1, SP2), each comprising a first transistor (ST1) and a second transistor (ST2),
wherein the second transistor (ST2) of each of the first and second pixels comprises:
an active region (ACT2);
a drain electrode (DE2) on one side of the first active region;
a source electrode (SE2) on the other side of the active region; and
a gate electrode (GE2) overlapping with the first active region,
wherein the first drain electrodes (DE2) of the second transistors (ST2) of the first and second pixels are respectively connected to the first and second data lines (DL1, DL2),
wherein the first gate electrode (GE2) of each of the second transistors (ST2) of the first and second pixels is connected to the auxiliary gate line (BGL1), and
wherein a branch point (BRP1) of the auxiliary gate line (BGL1) is located between the first and second data lines (DL1, DL2).

14. The display device of claim 13, wherein the first and second data lines (DL1, DL2) are located to one side of the first pixel (SP1).

15. The display device of claim 13 or 14, further comprising:
a third data line (DL3); and
a third pixel (SP3) comprising the second transistor (ST2),
wherein the drain electrode of the second transistor (ST2) of the third pixel is connected to the third data line (DL3),
wherein the gate electrode of the second transistor (ST2) of the third pixel is connected to the auxiliary gate line (BGL1),
wherein the first to third data lines and the auxiliary line are adjacent to each other and optionally wherein the auxiliary line overlaps with at least one of the first or second data lines.
